(19) **Europäisches Patentamt / European Patent Office / Office européen des brevets**

(11) **EP 4 452 847 B1**

(12) **EUROPÄISCHE PATENTSCHRIFT**

(45) Veröffentlichungstag und Bekanntmachung des Hinweises auf die Patenterteilung:
**04.03.2026   Patentblatt 2026/10**

(21) Anmeldenummer: **21830441.8**

(22) Anmeldetag: **20.12.2021**

(51) Internationale Patentklassifikation (IPC):
*C01B 33/021* (2006.01)   *C23C 16/24* (2006.01)
*C23C 16/44* (2006.01)   *H01M 4/134* (2010.01)
*C01B 33/029* (2006.01)   *C23C 16/04* (2006.01)
*H01M 4/36* (2006.01)   *H01M 4/38* (2006.01)

(52) Gemeinsame Patentklassifikation (CPC):
**C23C 16/045; C01B 33/029; C23C 16/24; C23C 16/4417; H01M 4/134; H01M 4/366; H01M 4/386;** Y02E 60/10

(86) Internationale Anmeldenummer:
**PCT/EP2021/086900**

(87) Internationale Veröffentlichungsnummer:
**WO 2023/117047 (29.06.2023 Gazette 2023/26)**

(54) **VERFAHREN ZUR HERSTELLUNG VON SILICIUM-ENTHALTENDEN MATERIALIEN IN EINEM RÜHRKESSELREAKTOR**

PROCESS FOR PRODUCING SILICON-CONTAINING MATERIALS IN A STIRRED-TANK REACTOR

PROCÉDÉ DE PRODUCTION DE MATÉRIAUX CONTENANT DU SILICIUM DANS UN RÉACTEUR À RÉSERVOIR AGITÉ

(84) Benannte Vertragsstaaten:
**AL AT BE BG CH CY CZ DE DK EE ES FI FR GB GR HR HU IE IS IT LI LT LU LV MC MK MT NL NO PL PT RO RS SE SI SK SM TR**

(43) Veröffentlichungstag der Anmeldung:
**30.10.2024   Patentblatt 2024/44**

(73) Patentinhaber: **Wacker Chemie AG**
**81671 München (DE)**

(72) Erfinder:
- **DRÄGER, Christoph**
  **81369 München (DE)**
- **BECKER, Moritz**
  **84489 Burghausen (DE)**
- **FRICKE, Michael**
  **84489 Burghausen (DE)**
- **KALYAKINA, Alena**
  **81379 München (DE)**
- **KLEINLEIN, Claudia**
  **84489 Burghausen (DE)**
- **KNEISSL, Sebastian**
  **83059 Kolbermoor (DE)**
- **SUCKOW, Sebastian**
  **84489 Burghausen (DE)**
- **TILLMANN, Jan**
  **80636 München (DE)**

(74) Vertreter: **Belz, Ferdinand et al**
**Wacker Chemie AG**
**Gisela-Stein-Straße 1**
**81671 München (DE)**

(56) Entgegenhaltungen:
**EP-A1- 2 889 097        GB-B- 2 580 110**
**US-A1- 2020 240 013**

**Beschreibung**

Verfahren zur Herstellung von Silicium enthaltenden Materialien durch thermische Zersetzung von Silicium-Präkursoren in Anwesenheit von porösen Partikeln, wobei Silicium in Poren und auf der Oberfläche der porösen Partikel in einem gasdurchströmten Reaktor mit einem wandgängigen Rührer abgeschieden wird. Als Speichermedien für elektrischen Strom sind Lithium-Ionen-Batterien gegenwärtig die praxistauglichsten elektrochemischen Energiespeicher mit den höchsten Energiedichten. Lithium-Ionen-Batterien werden vor allem im Bereich der tragbaren Elektronik, für Werkzeuge und auch für elektrisch angetriebene Transportmittel, wie Fahrräder, Roller oder Automobile, genutzt. Als Aktivmaterial für die negative Elektrode ("Anode") entsprechender Batterien ist gegenwärtig graphitischer Kohlenstoff weit verbreitet. Nachteilig ist jedoch die relativ niedrige elektrochemische Kapazität von derartigen graphitischen Kohlenstoffen, die theoretisch höchstens 372 mAh pro Gramm Graphit beträgt und somit nur etwa einem Zehntel der mit Lithiummetall theoretisch erreichbaren elektrochemischen Kapazität entspricht. Alternative Aktivmaterialien für die Anode verwenden einen Zusatz von Silicium, wie beispielsweise in der EP 1730800 B1, der US 10,559,812 B2, der US 10,819,400 B2, oder der EP 3335262 B1 beschrieben. Silicium bildet mit Lithium binäre elektrochemisch aktive Legierungen, die sehr hohe elektrochemisch erreichbare Lithiumgehalte von bis zu 3579 mAh pro Gramm Silicium ermöglichen [M. Obrovac, V.L. Chevrier Chem. Rev. 2014, 114, 11444].

Die Ein- und Auslagerung von Lithium-Ionen in Silicium ist mit dem Nachteil verbunden, dass dabei eine sehr starke Volumenänderung eintritt, die bei vollständiger Einlagerung bis zu 300% erreichen kann. Derartige Volumenänderungen setzen das Silicium-enthaltende Aktivmaterial einer starken mechanischen Belastung aus, auf Grund derer das Aktivmaterial schließlich auseinanderbrechen kann. Dieser auch als elektrochemische Mahlung bezeichnete Prozess führt im Aktivmaterial und in der Elektrodenstruktur zu einem Verlust der elektrischen Kontaktierung und damit zum nachhaltigen, irreversiblen Verlust der Kapazität der Elektrode.

Weiterhin reagiert die Oberfläche des Silicium-enthaltenden Aktivmaterials mit Bestandteilen des Elektrolyten unter kontinuierlicher Bildung passivierender Schutzschichten (Solid Electrolyte Interphase; SEI). Die gebildeten Komponenten sind nicht mehr elektrochemisch aktiv. Das darin gebundene Lithium steht dem System nicht mehr zur Verfügung, was zu einem ausgeprägten kontinuierlichen Kapazitätsverlust der Batterie führt. Aufgrund der extremen Volumenänderung des Siliciums während des Lade- bzw. Entladevorgangs der Batterie bricht die SEI regelmäßig auf, wodurch weitere, noch nicht belegte Oberflächen des Silicium-enthaltenden Aktivmaterials freigelegt werden, die dann einer weiteren SEI-Bildung ausgesetzt sind. Da in der Vollzelle die Menge an mobilem Lithium, welches der nutzbaren Kapazität entspricht, durch das Kathodenmaterial begrenzt ist, wird dieses zunehmend verbraucht und die Kapazität der Zelle sinkt bereits nach wenigen Zyklen in anwendungstechnisch inakzeptablem Ausmaß.

Die Abnahme der Kapazität im Laufe mehrerer Lade- und Entladezyklen wird auch als Fading oder kontinuierlicher Kapazitätsverlust bezeichnet und ist in der Regel irreversibel.

Als Aktivmaterialien für Anoden von Lithium-Ionen-Batterien sind eine Reihe von Silicium-Kohlenstoff-Kompositpartikel beschrieben worden, in denen das Silicium ausgehend von gasförmigen oder flüssigen Präkursoren in poröse Kohlenstoffpartikel eingelagert wird.

Es ist allgemein bekannt, dass bei mehrphasigen Reaktionssystemen eine gute Kontaktierung des porösen Feststoffs mit dem fluiden Präkursor notwendig ist [F. Schüth Chem. Unserer Zeit 2006, 40, 92-103].

Beispielsweise beschreibt die US 10,147,950 B2 die Abscheidung von Silicium aus Monosilan $SiH_4$ in einem porösen Kohlenstoff in einem Drehrohrofen oder vergleichbaren Ofentypen bei erhöhten Temperaturen von 300 bis 900°C, bevorzugt unter Bewegung der Partikel, durch einen CVD- ("chemical vapor deposition") oder PE-CVD-Prozess ("plasma-enhanced chemical vapor deposition"). Dabei kommt eine Mischung von 2 mol-% Monosilan mit Stickstoff als Inertgas zum Einsatz. Die geringe Konzentration des Silicium-Präkursors im Gasgemisch führt dabei zu sehr langen Reaktionszeiten. Zudem ist das Verhältnis von Schüttung zu Reaktorvolumen in einem Drehrohrofen meist sehr ungünstig, da es ansonsten zu einem erheblichen Partikelaustrag durch den Gasstrom kommt.

Eine weitere Methode für die Durchführung von Gas-Feststoff-Reaktionen und damit auch für den Einlagerungsprozess von Silicium in poröse Ausgangsstoffe sind Gaswirbelschichten. In einer Gaswirbelschicht wird eine Schüttung aus Feststoffpartikeln durch ein aufwärts strömendes Gas so weitgehend aufgelockert und getragen, dass die Feststoffschicht als Ganzes flüssigkeitsähnliches Verhalten zeigt [VDI-Wärmeatlas 11. Auflage, Abschnitt L3.2 Strömungsformen und Druckverlust in Wirbelschichten, S. 1371 - 1382, Springer Verlag, Berlin Heidelberg, 2013].

Gaswirbelschichten werden allgemein auch als Wirbelschichten oder auch als Wirbelbetten bezeichnet. Der Vorgang zur Erzeugung einer Wirbelschicht wird auch als Fluidisierung oder Fluidisieren bezeichnet.

In einer Gaswirbelschicht liegen die Feststoffpartikel sehr gut dispergiert vor. Folglich bildet sich eine sehr große Kontaktfläche zwischen Feststoff und Gas aus, die ideal für Energie- und Stoffaustauschprozesse genutzt werden kann. Gaswirbelschichten sind generell durch sehr gute Stoff- und Wärmeübergangsvorgänge und durch eine gleichmäßige Temperaturverteilung charakterisiert. Die Güte der Stoff- und Wärmeübergangsprozesse ist insbesondere für die Homogenität von durch Reaktionen in Wirbelschichten erhaltenen Produkten entscheidend und lässt sich mit der Homogenität des Fluidisierungszustands korrelieren. Folglich ist die Ausbildung einer homogenen Wirbelschicht bzw.

eines homogenen Fluidisierungszustands essenziell für die Nutzung des Wirbelschichtprozesses zur Herstellung von Produkten mit gleichen Produkteigenschaften.

In Abhängigkeit von der Partikelgröße und der Feststoffdichte der Partikel können die Fluidisierungseigenschaften klassifiziert werden. Beispielsweise fallen Partikel mit einer Partikelgröße $d_{50} < 20\,\mu m$ und mit einer Dichtedifferenz zwischen Partikel und Gas $> 1000\,kg/m^3$ in die Geldart-Klasse C (kohäsiv) [D. Geldart, Types of gas fluidization, Powder Technology 7 (1973) 258]. Partikel der Geldart-Klasse C sind dadurch gekennzeichnet, dass sie schlecht in einen fluidisierten Zustand überführt werden können. Aufgrund ihrer geringen Partikelgröße ist der Einfluss der interpartikulären Anziehungskräfte in der gleichen Größenordnung oder größer als die durch die Gasströmung auf die primären Partikel einwirkenden Kräfte. Entsprechend treten Effekte wie die Anhebung des Wirbelbettes als Ganzes und/oder Kanalbildung auf. Bei der Kanalbildung bilden sich anstelle einer Wirbelschicht Röhren in der Partikelschüttung aus, durch die das Fluidisiergas bevorzugt strömt, während der größte Teil der Schüttung gar nicht durchströmt wird. Dadurch wird keine Homogenität der Fluidisierung erreicht. Wird die Gasgeschwindigkeit deutlich über die minimale Fluidisierungsgeschwindigkeit der primären Partikel der Schüttung erhöht, so bilden sich mit der Zeit Agglomerate bestehend aus Einzelpartikeln aus, die vollständig oder teilweise fluidisiert werden können. Ein typisches Verhalten ist die Ausbildung von Schichten mit Agglomeraten unterschiedlicher Größe. In der untersten Schicht direkt über dem Anströmboden befinden sich dabei sehr große Agglomerate, die sehr wenig bis keine Bewegung aufweisen. In der darüberliegenden Schicht befinden sich kleinere Agglomerate, die fluidisiert sind. In der obersten Schicht liegen die kleinsten Agglomerate vor, die teilweise von der Gasströmung mitgerissen werden, was verfahrenstechnisch problematisch ist. Das Fluidisierungsverhalten derartiger Partikelschüttungen ist zusätzlich durch Bildung von großen Gasblasen und einer geringen Expansion des Wirbelbetts gekennzeichnet. In der englischsprachigen Literatur wird dieses Verhalten als "agglomerate bubbling fluidization" (ABF) bezeichnet. [Shabanian, J.; Jafari, R.; Chaouki, J., Fluidization of Ultrafine Powders, IRECHE., Vol.4, N.1, 16-50].

Dem Fachmann ist klar, dass ABF-Wirbelschichten aufgrund der Inhomogenitäten innerhalb des Wirbelbetts und der damit verbundenen inhomogenen Stoff- und Wärmeübergangsbedingungen für die Produktion von Stoffen mit homogenen Eigenschaften ungeeignet sind.

Aus diesem Grund werden in GB 2580110 B2 beispielsweise Partikel mit einer Größe ($D_{50}$) von mehr als 50 $\mu m$ in einer Wirbelschicht mit 1,25 Vol.-% Monosilan fluidisiert. Die so erhaltenen Partikel müssen nach der Beendigung der Reaktion allerdings auf die benötigte Zielgröße von $< 20\,\mu m$ vermahlen werden. Die Fluidisierung von Partikeln $< 20\,\mu m$ würde in dieser Wirbelschicht zu starken Agglomerationen und einer inhomogenen Infiltration der porösen Kohlenstoffpartikel führen.

Es sind Fluidisierhilfsmittel bekannt, um Partikel $< 20\,\mu m$ in Form von Agglomeraten in eine überwiegend homogene Wirbelschicht zu überführen. In der US 7,658,340 B2 wird beispielsweise beschrieben, dass durch den Eintrag weiterer Kraftkomponenten wie Vibrationskräfte, magnetische Kräfte, akustische Kräfte, Rotations- bzw. Zentrifugalkräfte oder Kombinationen davon neben der Krafteinwirkung durch das Fluidisierungsgas die Größe der Agglomerate bestehend aus SiO$_2$-Nanopartikeln (Geldart-Klasse C) in der Wirbelschicht derart beeinflusst werden, dass sich ein überwiegend homogenes Wirbelbett ausbildet.

Cadoret et al. [Cadoret, L.; Reuge, N.; Pannala, S.; Syamlal, M.; Rossignol, C.; Dexpert-Ghys, J.; Coufort, C.; Caussat, B.; Silicon Chemical Vapor Deposition on macro and submicron powders in a fluidized bed, Powder Technol., 190, 185-191, 2009] beschreiben die Abscheidung von Silicium aus Monosilan SiH$_4$ auf nicht porösen sub-Mikrometer großen Titanoxidpartikeln in einem vibrierten Wirbelschichtreaktor. Durch den Vibrationseintrag konnten die Agglomerate auf den Größenbereich von 300 bis 600 $\mu m$ in der Wirbelschicht begrenzt werden.

Wirbelschichtverfahren ohne Fluidisierungshilfsmittel sind für den Einlagerungsprozess/Abscheideprozess von Silicium in porösen Matrixpartikeln ungeeignet, da sich Partikel in der Größe $< 20\,\mu m$ nicht homogen fluidisieren lassen. Durch das inhomogene Wirbelbett lassen sich keine homogenen Produkte erzeugen.

Wirbelschichtverfahren mit Fluidisierungshilfsmitteln sind für den Einlagerungsprozess/Abscheideprozess von Silicium in porösen Matrixpartikeln nachteilig, da für die Fluidisierung der Partikel $< 20\,\mu m$ ein großer technischer Aufwand betrieben werden muss. Der Zusatzaufwand ist mit hohen Aufwendungen/Kosten für die Investition und Instandhaltung verbunden.

Ein weiterer Nachteil der Silicum-Einlagerung mittels Wirbelschichtprozess mit Fluidisierungshilfsmitteln ist, dass sich im Laufe des Prozesses die Eigenschaften der Primärpartikel, wie die Partikeldichte oder die Oberflächenbeschaffenheit, ändern. Diese wirken sich in unbekannter Weise auf die Agglomeratbildung aus, die wiederum für die Prozessfahrweise bekannt sein sollte. Homogene Prozessbedingungen über die gesamte Prozesslaufzeit können nicht sichergestellt werden.

Ein weiterer Nachteil der Wirbelschichttechnik ist, dass aufgrund der Fluidisierung der Agglomerate bestehend aus den primären porösen Partikeln Gasströmungen benötigt werden, die zu einem Austrag an primären Partikeln und/oder kleineren Agglomeraten führt.

Ein grundsätzlicher Nachteil der Wirbelschichttechnik ist, dass der Fluidisiergasstrom zur Ausbildung eines homogenen Wirbelbetts von der Größe der in der Wirbelschicht befindlichen Partikel bzw. Agglomerate abhängt.

Hierdurch sind die Menge an zudosiertem Reaktivgas und die Kontaktzeit des Reaktivgases mit den porösen Partikeln abhängig vom Fluidisierungs- und Mischungszustand des Partikelbetts. Beispielsweise kann im Wirbelschichtprozess die Erhöhung der Kontaktzeit der gasförmigen Reaktivkomponente mit dem Partikelbett nur durch Verringerung der Gasgeschwindigkeit erfolgen. Die Gasgeschwindigkeit ist aber die entscheidende Größe zur Sicherstellung des Fluidisierungs- und Mischungszustands.

Eine Möglichkeit, die Nachteile der Wirbelschichttechnik zu lösen, ist die strömungsunabhängige Durchmischung der Partikelschüttung mit der Gasphase.

In US 2020/0240013 A1 wird die Abscheidung von Silicium aus einem Silicium-haltigen Gas auf Partikeln mit einer mittleren Partikelgröße im unteren Millimeterbereich in einem gerührten Bettreaktor beschrieben. Aufgrund der Partikelgröße ist davon auszugehen, dass das eingesetzte Schüttgut sehr gut fließfähig ist. Mit Hilfe des beschriebenen Apparats erfolgt der Austausch zwischen Gas und Feststoff durch den Einsatz einer zentralen Rührschnecke, durch die gleichzeitig das Reaktionsgas durch Öffnungen der gerührten Schüttung zugeführt wird. In der Anmeldeschrift wird insbesondere auf die Vorteile der Behandlung von Partikeln im Millimeterbereich abgezielt, da für Partikel in dieser Größe große Fluidisiergasströme notwendig sind, um die Partikel in den fluidisierten Zustand zu überführen.

Der eingesetzte Rührer in US 2020/0240013 A1 ist jedoch für die Umwälzung von kohäsiven Partikeln < 20 $\mu$m ungeeignet.

Aus der Fachliteratur ist bekannt, dass für die Umwälzung von Partikeln in einem gerührten Bett unterschiedlichste Rührorgane eingesetzt werden können [M. Müller, Feststoffmischen, Chemie Ingenieur Technik 2007, 79, 7]. Beispielsweise werden durch den Einsatz eines wandgängigen Wendelrührers die Partikel im Reaktor seitlich nach oben transportiert, wodurch sich ein Zirkulationsstrom mit Relativbewegung der Partikel durch nachrutschendes Material ergibt. Ein Anhaften der Partikel an der Reaktorwand wird verhindert.

Eine Kenngröße zur Beschreibung des Bewegungszustands des Partikelbetts erfolgt über die Froude-Zahl (Fr), die das Verhältnis von Zentrifugalkraft zu Gewichtskraft im rotierenden System angibt.

$$Fr = \frac{r_c \omega^2}{g}$$

Hierbei ist $r_c$ der für das System relevante charakteristische Radius. Für Systeme mit rotierendem Mischwerkzeug entspricht $r_c$ dem Außenradius des Rührorgans. Bei Systemen mit rotierender Trommel ist $r_c$ der Innenradius des Behälters. Die Kreisfrequenz $\omega = 2\pi n$ hängt von der Drehzahl $n$ des rotierenden Systems ab. Der Einfluss der Gewichtskraft wird über die Erdbeschleunigung g berücksichtigt. Bei kleinen Froude-Zahlen überwiegt der Anteil der Gewichtskraft, wodurch der radiale Materialtransport gering ist. Die Partikelschüttung wird nur unzureichend umgewälzt. Bei großen Froude-Zahlen hingegen dominiert der Anteil der Zentrifugalkraft, wodurch das Material zu stark an die Behälterwand gefördert wird. Auch hier wird die Partikelschüttung nur unzureichend umgewälzt.

Ein Parameter zur Beschreibung der Kontaktzeit zwischen der Gasphase und dem gerührten Partikelbett ist die Verweilzeit der gasförmigen Reaktivkomponente im Reaktor. Die mittlere Verweilzeit $t_V$ kann als Quotient aus Reaktorvolumen und dem Volumenstrom der dosierten Gasphase $\dot{V}_F$ berechnet werden:

$$t_V = \frac{V_R}{\dot{V}_F}$$

Ein weiteres wichtiges Maß zur Bewertung der homogenen Reaktionsbedingungen im gerührten Bettreaktor stellt das Verhältnis $t_u/t_v$ aus der Umwälzzeit des Partikelbetts $t_u$ zur Verweilzeit des Silicium-Präkursors $t_v$ dar. Die Umwälzzeit $t_u$ des Partikelbetts berechnet sich als Quotient aus dem Reaktorvolumen $V_R$ und dem Volumenstrom an umgewälzten Partikeln $\dot{V}_P$.

$$t_U = \frac{V_R}{\dot{V}_P}$$

Der Volumenstrom der durch das Rührorgan umgewälzten Partikel $\dot{V}_P$ wird als das durch das Rührorgan in tangentialer Richtung verdrängte Partikelvolumen pro Zeiteinheit definiert und wird allgemein durch die folgende Formel beschrieben:

$$\dot{V}_P = n\,2\pi \sum_i \int_{r_{R,innen,i}}^{r_{R,au\ss en,i}} r_{R,i}\big[h_{o,i}(r) - h_{u,i}(r)\big]dr_{R,i}$$

Der Volumenstrom an umgewälzten Partikeln ist das Produkt aus Drehzahl n und der Summe aller tangential verdrängten Volumina durch die einzelnen Rührelemente $i$ des Rührorgans. Die geometrischen Maße jedes einzelnen Rührelements werden durch den Abstand der inneren Kante des Rührorgans zur Drehachse $r_{R,innen,i}$, durch den Abstand der äußeren Kante des Rührorgans zur Drehachse $r_{R,au\ss en,i}$ sowie durch die obere Kontur $h_{o,i}(r)$ und untere Kontur $h_{u,i}(r)$ des jeweiligen Rührelements berücksichtigt.

Nimmt das Verhältnis $t_u/t_v$ Werte < 1 an, so ist der Umwälzvorgang der Partikel schneller als das Durchströmen des Betts mit einem Gas, wodurch eine gleichmäßige Verteilung des Gases mit den Partikeln vorliegt. Bei Werten des Verhältnisses $t_u/t_v$ > 1 durchströmt das Gas das gerührte Bett schneller als das Bett selbst umgewälzt wird. Hierdurch bilden sich im gerührten Bett Zonen mit unterschiedlichen Abscheidebedingungen aus, die zu einer inhomogenen Produktverteilung im Bett führen.

GB 2 580 110 B betrifft ein Verfahren zur Herstellung von elektroaktiven Materialien für Metall-Ionen Batterien

EP 2 889 097 A1 betrifft ein Verfahren zur Herstellung eines porösen elektroaktiven Materials.

US 2020/240013 A1 betrifft eine Vorrichtung zur Herstellung von Partikeln oder materialbeschichteten Partikeln durch Zersetzung eine s Präkursorgases in einem gerührten oder gemischten Partikelbett.

Vor diesem Hintergrund bestand die Aufgabe, ein Verfahren für die Herstellung Silicium-enthaltender Materialien, vorzugsweise mit hoher Speicherkapazität für Lithium-Ionen, welche bei Einsatz als Aktivmaterial in Anoden von Lithium-Ionen-Batterien eine hohe Zyklenfestigkeit ermöglichen, ausgehend von porösen Partikeln und Silicium-Präkursoren bereitzustellen, welches technisch einfach umsetzbar ist und die Nachteile der oben beschriebenen Verfahren des Stands der Technik, insbesondere in Bezug auf den Austrag von Partikeln, die Reaktionszeiten und die dazu nötige Infrastruktur, nicht aufweist.

Insbesondere ist gewünscht, den Totraum der nicht vom Rührer bewegten Schüttung möglichst klein zu halten. So wird das Material an den beheizten Teilen des Mantels möglichst effizient in Bewegung gehalten und die Energie von der Wand in die Schüttung befördert. Außerdem wird auf diese Weise die Anhaftung von Partikeln an der Wand verhindert.

Gegenstand der Erfindung ist ein Verfahren zur Herstellung von Silicium-enthaltenden Materialien durch thermische Zersetzung von Silicium-Präkursoren in Anwesenheit von porösen Partikeln, wobei Silicium in Poren und auf der Oberfläche der porösen Partikel abgeschieden wird,

wobei die thermische Zersetzung der Silicium Präkursoren in der Reaktionszone eines gasdurchströmten Reaktors stattfindet und die Partikel mittels eines in den beheizten Bereichen wandgängigen Rührers während der thermischen Zersetzung in der Reaktionszone umgewälzt werden,

wobei das Rührwerk wandgängig ist, wenn in der Gleichung 1

$$W(h) = \frac{u_R(h)}{u_B(h)} \qquad (1)$$

für die Hälfte aller Werte von $h$ die Wandgängigkeit $W(h)$ in der Reaktionszone $W(h)$ > 0,9 ist, wobei $u_R(h)$ = der äußere Umfang des Rührwerks in der Schnittfläche bei der Höhenkoordinate $h$ ist und $u_B(h)$ = der innere Umfang des Reaktors.

Überraschend wurde gefunden, dass durch den erfindungsgemäßen Einsatz eines wandgängigen Rührwerkzeugs sehr kleine Partikel, insbesondere Partikel < 20 $\mu$m in einem Reaktor so umgewälzt werden und der Gasstrom an Reaktivkomponente so dosiert wird, dass die Kontaktzeit zwischen Gasphase und Feststoff so lang ist, dass der Einbringungsprozess von Silicium in den porösen Partikeln homogen und mit großem Umsatz des Silicium-Präkursors stattfindet und gleichzeitig der Austrag an Partikeln mit dem Gasstrom aus dem Reaktor minimal ist.

Im Vergleich zum Wirbelschichtreaktor mit Fluidisierhilfsmitteln ist der gasdurchströmte gerührte Reaktor, Rührbettreaktor - englisch stirred bed reactor (SBR) -, konstruktiv einfacher aufgebaut, da im SBR eine geringere Menge an Gas komprimiert und vorgeheizt werden muss, weil das Gas nicht zum Fluidisieren genutzt wird. Es entstehen dadurch geringere Kosten für die zugehörigen Aggregate. Aufwendige Steuer- und Regelungstechnik für den Betrieb der Fluidisierhilfsmittel ist im Fall des SBR nicht notwendig. Im Vergleich zum FBR baut der SBR kleiner, da das gerührte Bett bei gleicher Masse ein geringeres Volumen einnimmt. Die spezifischen Investitionskosten sind geringer.

Im Vergleich zu GB 2580110 B2 sind mit dem erfindungsgemäßen Verfahren keine weiteren Prozessschritte notwendig.

Im Vergleich zum Wirbelschichtreaktor ist die Partikelumwälzung unabhängig von der Zuführung einer Gasphase. Es sind größere Verweilzeiten möglich, die zu höheren Umsätzen der Reaktivkomponenten führen.

Durch das Rühren im erfindungsgemäßen Verfahren werden die Partikel nur umgewälzt. Die Partikel werden durch den Rührer nicht aufgewirbelt.

Der Gasstrom wird vorzugsweise so bemessen, dass die Aufwirbelung der Partikel im erfindungsgemäßen Verfahren durch die Gasströmung minimal ist und damit der Partikelaustrag aus dem Reaktor ebenfalls minimal ist. Gleichzeitig wird der Gasstrom bevorzugt so bemessen, dass der Umsatz der eingesetzten Reaktivkomponenten maximal ist.

Homogene Abscheidebedingungen sind durch geeignete Parameterwahl von Rührerdrehzahl, ausgedrückt durch die dimensionslose Froude-Zahl und durch eine geeignete Dosierrate möglich.

Gegenüber US 2020/0240013 A1 wird das erfindungsgemäße Verfahren durch den Einsatz eines wandgängigen Rührers verbessert.

Die Rührerdrehzahl wird vorzugsweise so eingestellt, dass die Umwälzzeiten des Partikelbetts kleiner sind als die Verweilzeiten der fluiden Reaktivkomponente, insbesondere der porösen Partikel. Dadurch wird eine ausreichend gute Makrovermischung der fluiden Phase mit der Feststoffphase realisiert, die zu einer homogenen Behandlung aller Partikel in der Feststoffphase führt.

Ein weiterer ökonomischer Vorteil des Verfahrens besteht im Gegensatz zu den nicht erfindungsgemäßen Verfahren in der höheren Silicium-Ausbeute. Zudem erfolgt eine besonders gleichmäßige Abscheidung von Silicium auf und vor allem in den porösen Partikeln, was zu einer hohen Stabilität des resultierenden Silicium-enthaltenden Materials in der Anwendung als Aktivmaterial in Anoden für Lithium-Ionen-Batterien bei gleichzeitig niedriger Volumenänderung in der Zyklisierung führt.

Die Wandgängigkeit $W(h)$ eines Rührwerks in einem rotationssymmetrischen Reaktor ist als der Quotient der Umfänge zweier ebener Schnittflächen senkrecht zur Rotationsachse von zwei Rotationsflächen definiert, wobei $h$ die Höhenkoordinate darstellt. Die innere Rotationsfläche wird durch einen vollständigen Umlauf des Rührwerks gebildet und ist durch den Abstand $r_R(h)$ von der Rotationsachse zur äußeren Kontur des Rührwerks charakterisiert. Zum Rührwerk zählen alle daran befestigten Bauteile. Ein ebener Schnitt an jeder beliebigen Stelle $h$ der Rotationsfläche senkrecht zur Rotationsachse bildet eine kreisförmige Schnittfläche. Der Umfang der inneren Schnittfläche berechnet sich mit

$$u_R(h) = 2\pi r_R(h)$$

Die äußere Rotationsfläche wird durch Rotation der inneren Kontur des Reaktors um die Rotationsachse gebildet. Sie wird durch den Abstand $r_B(h)$ beschrieben. Zur inneren Kontur des Reaktors zählen alle daran befestigten Bauteile. Der Umfang einer beliebigen Schnittfläche der äußeren Rotationsfläche senkrecht zur Rotationsachse berechnet sich mit

$$u_B(h) = 2\pi r_B(h)$$

Mit Hilfe der Umfänge ist die Wandgängigkeit wie folgt definiert:

$$W(h) = \frac{u_R(h)}{u_B(h)}$$

Im Allgemeinen kann ein Reaktor ein oder mehrere Rührwerke enthalten. Die Kontur jedes einzelnen Rührwerks bildet durch den vollständigen Umlauf eine Rotationsfläche. Diese Rotationsflächen können separat vorliegen. Bevorzugt können sie sich überlagern. Werden die einzelnen Rotationsflächen oder wird die überlagerte Rotationsfläche an beliebiger Stelle senkrecht zur Rotationsachse bzw. zu den Rotationsachsen geschnitten, so ergeben sich Figuren oder eine Figur, deren Umfang ermittelt werden kann. Ergeben sich mehrere Figuren, so wird der Gesamtumfang durch Summation der einzelnen Umfänge bestimmt.

Im Allgemeinen kann der Reaktor aus einem oder mehreren Reaktorteilen bestehen, die bevorzugt jeweils rotationssymmetrisch und miteinander verbunden sind. Die Gesamtheit aller Reaktorwände umhüllen eine Figur. Wird diese Figur an beliebiger Stelle senkrecht zur Rotationsachse der Rührwerke geschnitten, so ist der Umfang der sich ergebenden Figur bestimmbar. Die Wandgängigkeit $W(h)$ wird in analoger Weise wie für den rotationssymmetrischen Reaktor berechnet.

Die Wandgängigkeit kann mit $h$ variieren. Die erfindungsgemäße Ausführung des Rührers ist gegeben, wenn für mindestens die Hälfte aller Werte von $h$ die Wandgängigkeit $W(h)$ in der Reaktionszone $W(h) > 0{,}9$ ist; hierfür wird $W(h_{50\%})$ definiert. In einer bevorzugten Ausführungsform ist $W(h_{50\%}) > 0{,}95$. In einer besonders bevorzugten Ausführungsform ist $W(h_{50\%}) > 0{,}97$. In einer ganz besonders bevorzugten Ausführungsform ist $W(h_{50\%}) > 0{,}99$. Die Reaktionszone ist der Bereich im Reaktor, in dem das gerührte Partikelbett mit der Reaktivkomponente in Kontakt gebracht wird und die Reaktivkomponente zersetzt wird. Für spezielle Fälle des Verfahrens sind auch Werte für $W(h_{50\%}) > 1$ möglich.

Vorzugsweise wird das Verfahren in einem Kaskadenreaktorsystem umfassend mehrere Reaktoren durchgeführt.

Die Durchführung im Kaskadenreaktor hat gegenüber der Durchführung in nur einem Reaktor den Vorteil, dass die langen Abkühl- und Aufheizphasen eines Reaktors vermindert werden. Dies birgt einen zeitlichen und energietechnischen Vorteil gegenüber nur einem Reaktor und führt zu einer geringeren Materialbeanspruchung der Reaktoren. Das Kaskadenreaktorsystem bietet außerdem den Vorteil, dass die einzelnen Reaktoren genau auf ihren Zweck ausgelegt werden können. Das Kaskadenreaktorsystem ist zudem besser skalierbar, da unterschiedlich viele Reaktoren zu den einzelnen Phasen miteinander kombiniert werden können.

In einer bevorzugten Ausführungsform umfasst das Verfahren zumindest die Phasen 1 bis 3:

Phase 1: Befüllen eines Reaktors A mit porösen Partikeln und Vorbehandlung der Partikel mit anschließendem Transfer der vorbehandelten Partikel in einen Reaktor B

oder in einen Vorratsbehälter, oder das Material verbleibt im Reaktor A.

Phase 2: Durchströmung von Reaktor B mit einem Gas bestehend aus einem Inertgas und/oder mindestens einer Reaktivkomponente enthaltend einen Silicium-Präkursor und/oder mindestens einen Silicium-freien Präkursor, Temperieren des Reaktors auf eine Temperatur, bei der die thermische Zersetzung der Reaktivkomponente auf der Oberfläche und in den Poren der porösen Partikel stattfindet. Das Partikelbett in Reaktor B wird mit einem wandgängigen Rührer so umgewälzt, dass der Bewegungszustand der Schüttung mit Froude-Zahlen im Bereich zwischen 1 und 10 beschrieben werden kann. Die Gasphase wird Reaktor B zugeführt, während das Partikelbett in Reaktor B durch ein wandgängiges Rührorgan so umgewälzt wird, dass das Verhältnis aus Umwälzzeit zur mittleren Verweilzeit der Reaktivkomponente kleiner als 1 ist. Die Reaktion kann sowohl im Unter- als auch im Überdruck ablaufen. Nach der Einbringung des Siliciums in und auf die Poren der porösen Partikel werden die Silicium-enthaltenden Materialien in Reaktor C oder zur Zwischenlagerung in einen Vorratsbehälter überführt oder das Material verbleibt im Reaktor B.

Phase 3: Nachbehandlung der Silicium-enthaltenden Partikel zur Funktionalisierung und/oder Beschichtung der Oberfläche der Silicium-enthaltenden Partikel. Abkühlen der Partikel auf eine definierte Temperatur und Entnahme von Silicium-enthaltenden Materialien aus Reaktor C, und vorzugsweise direkte Überführung in einen Vorratsbehälter oder direkte Abfüllung in ein geeignetes Gebinde.

In Phase 1 werden poröse Partikel in einen beheizbaren und/oder vakuumfesten und/oder druckfesten Reaktor A befüllt. Diese Befüllung kann manuell oder automatisch erfolgen.

Das Befüllen von Reaktor A mit porösen Partikeln kann beispielsweise unter Inertgasatmosphäre oder vorzugsweise Umgebungsluft durchgeführt werden. Als Inertgas können beispielsweise Wasserstoff, Helium, Neon, Argon, Krypton, Xenon, Stickstoff oder Kohlendioxid oder Gemische hiervon, wie beispielsweise Formiergas, eingesetzt werden. Bevorzugt sind Argon oder insbesondere Stickstoff.

Die automatische Befüllung kann zum Beispiel mittels Dosierschnecke, Zellenrad, Rüttelrinne, Tellerdosierer, Banddosierer, Vakuumdosiersystem, Negativ-Verwiegung oder sonstigem Dosiersystem aus zum Beispiel einem Silo, einer Sackschütte oder sonstigem Containersystem erfolgen.

Ziel der Vorbehandlung der Partikel in Reaktor A in Phase 1 ist die Entfernung von Luft bzw. Sauerstoff, Wasser oder von Dispergiermitteln, wie beispielsweise Tenside oder Alkohole, und Verunreinigungen aus den Partikeln. Dieses kann erreicht werden durch Inertisierung mit Inertgas, Erhöhung der Temperatur auf bis zu 1000 °C, Reduktion des Drucks auf bis zu 0,01 mbar oder einer Kombination der einzelnen Prozessschritte. Als Inertgas können beispielsweise Wasserstoff, Helium, Neon, Argon, Krypton, Xenon, Stickstoff oder Kohlendioxid oder Gemische hiervon, wie beispielsweise Formiergas, eingesetzt werden. Bevorzugt sind Argon oder insbesondere Stickstoff.

Ziel der Vorbehandlung in Phase 1 kann außerdem die Veränderung der chemischen Oberflächenbeschaffenheit der porösen Partikel mit weiteren Substanzen sein. Die Zugabe kann vor oder nach der Trocknung erfolgen, und es kann ein weiterer Heizschritt erfolgen, bevor das Material in Reaktor B transferiert wird. Die Substanzen können gasförmig, fest, flüssig oder als Lösung in den Reaktor gegeben werden, auch Mischungen, Emulsionen, Suspensionen, Aerosole oder Schäume sind möglich. Hierbei kann es sich beispielsweise um Kohlendioxid, Wasser, Natronlauge, Kalilauge, Flusssäure, Phosphorsäure, Salpetersäure, Salzsäure, Ammoniak, Ammoniumdihydrogenphosphat, Lithiumnitrat, Natriumnitrat, Kaliumnitrat, Lithiumchlorid, Natriumchlorid, Kaliumchlorid, Lithiumbromid, Natriumbromid, Kaliumbromid, Alkanolate handeln.

Der Transfer der porösen Partikel in einen weiteren Reaktor oder Behälter kann beispielsweise durch ein Fallrohr, Stetigförderer, Strömungsförderer/Saug- oder Druckförderanlage (z.B. Vakuumförderer, Transportgebläse);

Mechanische Förderer (z.B. Rollenförderer mit Antrieb, Schneckenförderer, Kreisförderer, Umlaufförderer , Becherwerk, Zellenradschleusen, Kettenförderer, Kratzerförderer, Bandförderer, Schwingförderer); Schwerkraftförderer (z.B. Rutschen, Rollenbahn, Kugelbahn, Schienen-bahn),sowie mittels Unstetigförderer Flurgebunden Schienenfrei (z.B. Automatikfahrzeug, Hand-Gabelhubwagen, Elektro-Gabelhubwagen), Fahrerlose Transportsysteme (FTS), Luftkissenfahrzeug, Handkarren, Elektrokarren, Motorfahrzeug (Schlepper, Wagen, Stapler), Verschiebewagen, Verschiebehubwagen, Regalbediengerät (ohne/mit Umsetzer, kurvengängig); Flurgebunden Schienengebunden (z.B. Betriebsbahn, Gleiswagen); Flurfrei (z.B. Trolleybahn), Krane (z.B. Brückenkran, Portalkran, Auslegerkran, Turmkran), Elektrohängebahn (EHB), Kleinbehältertransportanlage; Stationär (z.B. Aufzug, Hebebühne und Hubarbeitsbühne, Schrittförderer) erfolgen.

In Phase 2 wird das vorbehandelte Material in Reaktor B vorzugsweise auf eine Temperatur von 100 bis 1000 °C gebracht, besonders bevorzugt 250 bis 600 °C und insbesondere bevorzugt 300 bis 500 °C.

Reaktor B wird während der Veränderung der Temperatur oder bei erreichter Temperatur oder beim Durchlaufen eines Temperaturprofils abwechselnd oder gleichzeitig mit einem Gas bestehend aus mindestens einem Inertgas und/oder mindestens einer Reaktivkomponente bestehend aus mindestens einen Silicium-Präkursor und/oder mindestens einen Silicium-freien Präkursor durchströmt. Unterschiedliche Zusammensetzungen des Gases sind nacheinander möglich oder werden während der Phase 2 im Rahmen der angegebenen Zusammensetzung variiert. Die Porenvolumenbezogene Dosierrate der Reaktivkomponente enthaltenden Gasphase mit mindestens einem Silicium-Präkursor ist definiert als pro Stunde zugeführte Masse an Silicium [g] enthaltend im Silicium-Präkursor, bezogen auf das absolute Porenvolumen [$cm^3$] aller in Reaktor B eingebrachten porösen Partikel. Vorzugsweise wird über den Verlauf der Abscheidung der Silicium-Präkursor mit einer Rate von 0,1-2 g, besonders bevorzugt 0,5 bis 1,5 g Si pro $cm^3$ Porenvolumen der eingesetzten porösen Partikel und Stunde zudosiert.

Alternativ ist die Flächen-bezogene Dosierrate der Reaktivkomponente enthaltenden Gasphase mit mindestens einem Silicium-Präkursor als pro Stunde zugeführte Masse an Silicium [kg] enthaltend im Silicium-Präkursor, bezogen auf die größte Strömungsquerschnittsfläche [$m^2$] in der Reaktionszone. Der Querschnitt wird anhand des leeren Reaktors gemessen. Die Reaktionszone ist der Bereich im Reaktor, in dem das gerührte Partikelbett mit der Reaktivkomponente in Kontakt gebracht wird und der Präkursor zersetzt wird.

Die Dosierrate an zugeführtem Präkursor wird so bemessen, dass das Verhältnis aus Umwälzzeit der Partikelschüttung zur mittleren Verweilzeit der Reaktivkomponente im Reaktor stets kleiner als 1 ist.

Die Zudosierung der Gasphase kann kontinuierlich oder stoßartig sein. Die Dosierrate kann während der Reaktionslaufzeit variieren.

Vorzugsweise wird im rotationssymmetrischen Reaktor der Silicium-Präkursor über den Verlauf der Abscheidung mit einer Rate von 1 - 700 kg, besonders bevorzugt 10 bis 300 kg Si pro $m^2$ der äußeren Rotationsfläche und Stunde zudosiert.

Der Reaktor B wird vorzugsweise mit einer solchen Menge an Silicium-enthaltender Reaktivkomponente über die Gesamtzeit der thermischen Zersetzung durchströmt, dass in Bezug auf die eingewogene Menge poröser Partikel eine für die Zielkapazität des herzustellenden Silicium-enthaltenden Materials ausreichende Menge Silicium abgeschieden wird.

Das Aufheizen von Reaktor B in Phase 2 kann beispielsweise mit einer konstanten Heizrate oder mit mehreren unterschiedlichen Heizraten erfolgen. Heizraten können vom Fachmann im Einzelfall je nach Ausgestaltung des Verfahrens angepasst werden, beispielsweise je nach Größe des Reaktors, der Menge der porösen Partikel im Reaktor, der Rührtechnologie oder der geplanten Reaktionszeit.

Bevorzugt erfolgt das Aufheizen von Reaktor B in Phase 2 mit Heizraten von 1 bis 100°C pro Minute, besonders bevorzugt mit Heizraten von 2 bis 50°C pro Minute.

Die Temperatur, bei der die Zersetzung des Silicium-Präkursors beginnt, kann beispielsweise von den eingesetzten porösen Partikeln, dem oder den eingesetzten Silicium-Präkursoren und den anderen Randbedingungen der Zersetzung, wie beispielsweise dem Partialdruck des Silicium-Präkursors zum Zeitpunkt der Zersetzung und der Anwesenheit von anderen Reaktivkomponenten, wie beispielsweise Katalysatoren, die die Zersetzungsreaktion beeinflussen, abhängen.

Während der Zersetzung der Silicium-Präkursoren in Phase 2 kann die Temperatur konstant gehalten oder auch variiert werden. Ziel ist der weitgehend vollständige Umsatz der Silicium-Präkursoren während der Kontaktzeit des Gases mit dem gerührten Bett unter Erzeugung eines für die Anwendung geeigneten Silicium-enthaltenden Materials.

Die Betttemperatur während Phase 2 und 3 und insbesondere der Reaktionszone des mit dem wandgängigen Rührer ausgestatteten Reaktors liegt vorzugsweise im Bereich von 100 bis 1000°C, besonders bevorzugt von 250 bis 600°C und am meisten bevorzugt von 300 bis 500°C. Beispielsweise liegen die Zieltemperaturen für $SiH_4$ bevorzugt zwischen 300 und 500°C, besonders bevorzugt im Bereich von 320 bis 450°C und ganz besonders bevorzugt im Bereich von 320 bis 430°C. Die Zieltemperaturen für $HSiCl_3$ liegen bevorzugt zwischen 380 und 1000°C, besonders bevorzugt im Bereich von 420 bis 600°C. Die Zieltemperaturen für $H_2SiCl_2$ liegen bevorzugt zwischen 350 und 800°C, besonders bevorzugt im Bereich von 380 bis 500°C.

Im Falle des Einsatzes von Kohlenwasserstoffen in der Phase 3 und/oder zusätzlich zur Siliciumabscheidung während der Phase 2 als weitere Reaktivkomponenten, die keinen Silicium-Präkursor enthalten, werden Zieltemperaturen angewendet, bei denen die Zersetzung der Kohlenwasserstoffe beginnt und Kohlenstoff in Poren und auf der Oberfläche der porösen Partikel abgeschieden wird. Vorzugsweise werden die Zieltemperaturen in dieser Ausführungsform im Bereich von 250 bis 1000°C, besonders bevorzugt von 350 bis 850°C und am meisten bevorzugt von 400 bis 650°C gewählt.

In Phase 2 wird die Schüttung bestehend aus porösen Partikeln vorzugsweise kontinuierlich umgewälzt. Die Umwälzung erfolgt über ein oder mehrere Rührorgane oder über eine rotierende Bewegung des Reaktors selbst (Beispielsweise Intensivmischer der Fa. Maschinenfabrik Gustav Eirich) oder Kombinationen daraus. Der Bewegungszustand der bewegten Schüttung wird durch Froude-Zahlen zwischen 1 und 10 charakterisiert. Vorzugsweise liegt die Froude-Zahl zwischen 1 und 6. Besonders bevorzugt zwischen 1 und 4.

Die thermische Zersetzung der Silicium-Präkursoren in Anwesenheit von porösen Partikeln findet vorzugsweise bei 0,05 MPa bis 5 Mpa, besonders bevorzugt bei 0,08 bis 0,7 Mpa statt.

Die Gasphase aus Phase 2 besteht aus einem Inertgas und/oder mindestens einer Reaktivkomponente enthaltend einen Silicium-Präkursor und/oder mindestens einen Silicium-freien Präkursor in möglicherweise variierender Zusammensetzung. Der eine oder die mehreren Silicium-Präkursoren können allgemein gemischt oder getrennt oder in Mischung mit Inertgasbestandteilen oder als Reinstoffe in Reaktor B eingebracht werden. Bevorzugt enthält die Reaktivkomponente einen Inertgasbestandteil von 0 bis 99%, besonders bevorzugt höchstens 50%, insbesondere bevorzugt höchstens 30% und ganz besonders bevorzugt höchstens 5%, bezogen auf den Partialdruck des Inertgasbestandteils am Gesamtdruck der Reaktivkomponente unter Normbedingungen (nach DIN 1343).

Die Silicium-enthaltende Reaktivkomponente enthält mindestens einen Präkursor, welcher unter den gewählten Bedingungen, beispielsweise thermischer Behandlung, zu Silicium reagieren kann. Der Präkursor wird bevorzugt aus der Gruppe ausgewählt enthaltend Silicium-Wasserstoff-Verbindungen wie Monosilan $SiH_4$, Disilan $Si_2H_6$ sowie höhere lineare, verzweigte oder auch zyklische Homologe, neo-Pentasilan $Si_5H_{12}$, cyclo-Hexasilan $Si_6H_{12}$, Chlor-haltige Silane, wie beispielsweise Trichlorsilan $HSiCl_3$, Dichlorsilan $H_2SiCl_2$, Chlorsilan $H_3SiCl$, Tetrachlorsilan $SiCl_4$, Hexachlordisilan $Si_2Cl_6$, sowie höhere lineare, verzweigte oder auch cyclische Homologe wie beispielsweise 1,1,2,2-Tetrachlordisilan $Cl_2HSi\text{-}SiHCl_2$, chlorierte und teilchlorierte Oligo- und Polysilane, Methylchlorsilane, wie beispielsweise Trichlormethylsilan $MeSiCl_3$, Dichlordimethylsilan $Me_2SiCl_2$, Chlortrimethylsilan $Me_3SiCl$, Tetramethylsilan $Me_4Si$, Dichlormethylsilan $MeHSiCl_2$, Chlormethylsilan $MeH_2SiCl$, Methylsilan $MeH_3Si$, Chlordimethylsilan $Me_2HSiCl$, Dimethylsilan $Me_2H_2Si$, Trimethylsilan $Me_3SiH$ oder auch Mischungen aus den beschriebenen Siliciumverbindungen.

In einer speziellen Ausführungsform des Verfahrens wird das Monosilan oder Mischungen aus Silanen wie z.B. Mischungen aus Monosilan $SiH_4$, Trichlorsilan $HSiCl_3$, Dichlorsilan $H_2SiCl_2$, Monochlorsilan $H_3SiCl$ und Tetrachlorsilan $SiCl_4$, wobei jeder Bestandteil von 0 bis 99,9 Gew.-% vorliegen kann, erst mit einem geeigneten Verfahren direkt vor dem Einsatz im Reaktor hergestellt. In der Regel gehen diese Verfahren von Trichlorsilan $HSiCl_3$ aus, das an einem geeigneten Katalysator (z.B. AmberLyst™ A21DRY) zu den anderen Komponenten der beschriebenen Mischung umgelagert wird. Die Zusammensetzung der entstehenden Mischung wird hauptsächlich durch die Aufarbeitung der, nach ein oder mehreren Umlagerungsstufen, bei einer oder mehreren unterschiedlichen Temperaturen, entstandenen Mischung bestimmt. Besonders bevorzugte Reaktivkomponenten werden ausgewählt aus der Gruppe umfassend Monosilan $SiH_4$, oligomere oder polymere Silane, insbesondere lineare Silane der allgemeinen Formel $Si_nH_{n+2}$, wobei n eine ganze Zahl im Bereich 2 bis 10 umfassen kann sowie cyclische Silane der allgemeinen Formel $-[SiH_2]_n-$, wobei n eine ganze Zahl im Bereich 3 bis 10 umfassen kann, Trichlorsilan $HSiCl_3$, Dichlorsilan $H_2SiCl_2$ sowie Chlorsilan $H_3SiCl$, wobei diese allein oder auch als Mischungen zum Einsatz kommen können, ganz besonders bevorzugt kommen $SiH_4$, $HSiCl_3$ und $H_2SiCl_2$ allein oder in Mischung zum Einsatz.

Während des Dosierens der Reaktivkomponenten in die Reaktoren können die Bestandteile der Reaktivkomponente beispielsweise in gasförmiger, flüssiger oder sublimierbarer fester Form vorliegen.

Die Reaktivkomponente ist bevorzugt gasförmig, flüssig, fest, beispielsweise sublimierbar, oder eine Stoffmischung gegebenenfalls bestehend aus Stoffen in verschiedenen Aggregatzuständen. In einer Variante des Verfahrens wird die Reaktivkomponente direkt in die Schüttung aus porösen Partikeln im Reaktor gegeben, beispielsweise von unten oder von der Seite oder durch einen speziellen Rührer.

Darüber hinaus können die Reaktivkomponenten in Phase 2 und/oder 3 zusätzlich auch weitere reaktive Bestandteile enthalten, wie Dotierstoffe beispielsweise auf Basis von Bor, Stickstoff, Phosphor, Arsen, Germanium, Eisen oder auch Nickel enthaltender Verbindungen. Die Dotierstoffe werden bevorzugt ausgewählt aus der Gruppe umfassend Ammoniak $NH_3$, Diboran $B_2H_6$, Phosphan $PH_3$, German $GeH_4$, Arsan $AsH_3$, Eisenpentacarbonyl $Fe(CO)_4$ und Nickeltetracarbonyl $Ni(CO)_4$.

Weitere reaktive Bestandteile, die in der Gasphase enthalten sein können, umfassen Wasserstoff oder auch Kohlenwasserstoffe, ausgewählt aus der Gruppe enthaltend aliphatische Kohlenwasserstoffe mit 1 bis 10 Kohlenstoffatomen, bevorzugt 1 bis 6 Kohlenstoffatomen, wie beispielsweise Methan, Ethan, Propan, Butan, Pentan, Isobutan, Hexan, Cyclopropan, Cyclobutan, Cyclopentan, Cyclohexan, Cycloheptan; ungesättigte Kohlenwasserstoffe mit 1 bis 10 Kohlenstoffatomen wie beispielsweise Ethen, Acetylen, Propen, Methylacetylen, Butylene, Butine (1-Butin, 2-Butin), Isopren, Butadien, Divinylbenzol, Vinylacetylen, Cyclohexadien, Cyclooctadien, zyklische ungesättigte Kohlenwasserstoffe, wie beispielsweise Cyclopropen, Cyclobuten, Cyclopenten, Cyclohexen, Cyclohexadien, Cyclopentadien, Dicyclopentadien oder Norbornadien, aromatische Kohlenwasserstoffe, wie beispielsweise Benzol, Toluol, p-,m-,o-Xylol, Styrol (Vinylbenzol), Ethylbenzol, Diphenylmethan oder Naphthalin, weitere aromatische Kohlenwasserstoffe, wie beispielsweise Phenol, o-, m-, p-Kresol, Cymol, Nitrobenzol, Chlorbenzol, Pyridin, Anthracen oder Phenanthren, Myrcen, Geraniol, Thioterpineol, Norbornan, Borneol, iso-Borneol, Bornan, Campher, Limonen, Terpinen, Pinen, Pinan, Caren, Phenol, Anilin, Anisol, Furan, Furfural, Furfurylalkohol, Hydroxymethylfurfural, Bishydroxymethylfuran und gemischte Fraktionen, die eine Vielzahl solcher Verbindungen enthalten, wie beispielsweise aus Erdgaskondensaten, Erdöldestillaten oder Koksofenkondensaten, gemischte Fraktionen aus den Produktströmen eines Fluid-Catalytic-Crackers (FCC), Steam-Crackers oder einer Fischer-Tropsch-Syntheseanlage, oder ganz allgemein kohlenwasserstoffhaltige Stoffströme aus der Holz-, Erdgas-, Erdöl- und Kohleverarbeitung.

In einer besonders bevorzugten Ausführungsform wird in einem ersten Reaktionszyklus in Phase 2 eine Reaktivkomponente enthaltend zumindest einen Silicium-Präkursor beaufschlagt und im zweiten Reaktionszyklus in Phase 2 eine zumindest einen Kohlenwasserstoff enthaltende Reaktivkomponente beaufschlagt, welche vorzugweise Silicium-frei ist. Durch Wiederholen dieser beiden Schritte kann beispielsweise ein Silicium-enthaltendes Material erhalten werden, welches keine nach außen gerichtete freie Siliciumoberfläche aufweist.

Optional wird in einem vorgelagerten Reaktionszyklus in Phase 2 eine weitere Kohlenwasserstoff-haltige Silicium-freie Reaktivkomponente eingesetzt. Dadurch wird beispielsweise ein Silicium-enthaltendes Material erhältlich, welches zwischen den porösen Partikeln und dem abgeschiedenen Silicium eine Kohlenstoffschicht aufweist und welches gegebenenfalls zusätzlich eine äußere Kohlenstoffschicht trägt, wodurch keine nach außen gerichtete freie Siliciumoberfläche vorhanden ist.

In einer bevorzugten Ausführungsform werden die Temperatur, der Druck, Druckänderungen oder Differenzdruckmessungen und Gasflussmessungen in Reaktor B mit gängigen Messgeräten und Messmethoden bestimmt. Nach üblicher Kalibrierung ergeben unterschiedliche Messgeräte dieselben Messergebnisse.

Der Verlauf der Reaktion in Phase 2 wird bevorzugt analytisch verfolgt, um das Ende der Reaktion zu erkennen und so die Reaktorbelegungszeit möglichst gering zu halten. Verfahren zur Beobachtung des Reaktionsverlaufs umfassen dabei beispielsweise Temperaturmessung zum Feststellen einer Exo- oder Endothermie zur Feststellung des Reaktionsverlaufs durch sich ändernde Verhältnisse von festen zu gasförmigen Reaktorinhaltsbestandteilen sowie durch weitere Methoden, die die Beobachtung der sich verändernden Zusammensetzung des Gasraums während der Reaktion ermöglichen. In einer bevorzugten Variante des Verfahrens wird die Zusammensetzung der Gasphase durch einen Gaschromatographen und/oder Wärmeleitfähigkeitsdetektor und/oder ein Infrarotspektroskop und/oder ein Ramanspektroskop und/oder ein Massenspektrometer bestimmt werden. In einer bevorzugten Ausführungsform werden mittels eines Wärmeleitfähigkeitsdetektors der Wasserstoffgehalt und/oder etwaig vorhandene Chlorsilane mittels eines Gaschromatographen oder Gasinfrarotspektroskops bestimmt. In einer weiteren bevorzugten Variante des Verfahrens kommt ein technisches Bauteil zum Einsatz, das die Trennung von Wasserstoff und Silan ermöglicht. Diese Trennung kann beispielsweise über Filtration bzw. Membranverfahren (Lösungs-Diffusions- und Hydrodynamisches Modell), Adsorption, Chemisorption, Absorption bzw. Chemisorption oder Molsiebe (z.B. Zeolith) erfolgen. Dieses Bauteil ermöglicht im Fall von Wasserstoff als gasförmigen Reaktionsprodukt einen Kreisgasprozess. Hierbei wird das in Phase 2 ausgetragene Gas aufgereinigt bzw. der Anteil an Silicium-enthaltende Reaktivkomponente erhöht und wieder in den Reaktor zurückgeführt, bis die gewünschte Menge Silicium abgeschieden wurde. In einer anderen Ausführungsform wird das Gas in seine Bestandteile aufgetrennt und auf diese Weise entsorgt.

In einer weiteren bevorzugten Variante des Verfahrens ist der Reaktor B bzw. die Stelle des Gasaustrages mit einer technischen Möglichkeit ausgestattet, die zur Entfernung von auftretenden, kondensierbaren oder resublimierbaren Nebenprodukten dient. In einer besonders bevorzugten Variante wird hierbei Siliciumtetrachlorid kondensiert und separat vom Silicium-enthaltenden Material entfernt.

In einer bevorzugten Ausführungsform des Verfahrens werden die Dosiervorgänge in Phase 2 mehrfach wiederholt, wobei der jeweils in Phase 2 beaufschlagte Silicium-Präkursor jeweils gleich oder unterschiedlich sein kann, wobei auch Mischungen aus mehreren Silicium-Präkursoren möglich sind. Ebenfalls kann die in Phase 2 beaufschlagte Silicium-freie Reaktivkomponente jeweils gleich oder unterschiedlich sein oder aus Mischungen verschiedener Reaktivkomponenten bestehen. Nach der mehrfachen Wiederholung der einzelnen Dosiervorgänge in Phase 2 wird die Durchführung in Reaktor B mit der Überführung der Silicium-enthaltenden Partikel in Reaktor C beendet.

In Phase 3 des Verfahrens können die Silicium-enthaltenden Partikel in Reaktor C nachbehandelt und/oder deaktiviert und/oder beschichtet werden. Vorzugsweise wird hierzu Reaktor C mit Sauerstoff, insbesondere mit einem Gemisch aus Inertgas und Sauerstoff, gespült. Dadurch kann beispielsweise die Oberfläche des Silicium-enthaltenden Materials modifiziert und/oder funktionalisiert und/oder deaktiviert werden. Beispielsweise kann eine Reaktion etwaiger auf der Oberfläche des Silicium-enthaltenden Materials vorhandener, reaktiver Gruppen erreicht werden. Bevorzugt wird dazu eine Mischung von Stickstoff, Sauerstoff und gegebenenfalls Alkohole und/oder Wasser eingesetzt, die bevorzugt höchstens 20 Vol.-%, besonders bevorzugt höchstens 10 Vol.-% und insbesondere bevorzugt höchstens 5 Vol.-% Sauerstoff sowie bevorzugt höchstens 100 Vol.-%, besonders bevorzugt höchstens 10 Vol.-% und insbesondere bevorzugt höchstens 1 Vol.-% Wasser enthält. Dieser Schritt erfolgt bevorzugt bei Temperaturen von höchstens 250°C, besonders bevorzugt bei höchstens 100°C und insbesondere bevorzugt bei höchstens 50°C. Die Deaktivierung der Partikeloberflächen kann auch mit einem Gasgemisch, enthaltend Inertgas und Alkohole, erfolgen. Bevorzugt werden hier Stickstoff und Isopropanol eingesetzt. Es können aber auch Methanol, Ethanol, Butanole, Pentanole oder langkettigere und verzweigte Alkohole und Diole eingesetzt werden.

Die Deaktivierung der Partikel kann auch durch Dispergierung in einem flüssigen Lösemittel oder ein Lösemittelgemisch erfolgen. Dieses kann beispielsweise Isopropanol oder eine wässrige Lösung enthalten.

Wahlweise kann die Deaktivierung der Partikel in Phase 3 auch über eine Beschichtung mittels C-, Al-, B-haltiger Präkursoren bei Temperaturen von 200-800°C und optional anschließender Behandlung mit Sauerstoff-haltiger Atmosphäre erfolgen.

Als Aluminium-haltige Präkursoren können beispielsweise Trimethylaluminium ($(CH_3)_3Al$), Aluminium-2,2,6,6-tetramethyl-3,5-heptandionat ($Al(OCC(CH_3)_3CHCOC(CH_3)_3)_3$), Tris-(dimethylamido)-aluminium ($Al(N(CH_3)_2)_3$) und Aluminiumtriisopropanolat ($C_9H_{21}AlO_3$) eingesetzt werden.

Als Bor-haltige Präkursoren können beispielsweise Boran ($BH_3$), Triisopropylborat ($[(CH_3)_2CHO]_3B$), Triphenylboran ($(C_6H_5)_3B$) und Tris-(pentafluorophenyl)-boran $(C_6F_5)_3B$ eingesetzt werden. In Phase 3 können aber auch beispielsweise Nachbeschichtungen der Partikel mit Festkörperelektrolyten über thermische Zersetzungen von beispielsweise Tert-Butyllithium und Trimethylphosphat eingeführt werden.

In Phase 3 des Verfahrens werden grundsätzlich die Silicium-enthaltende Materialien, gegebenenfalls unter Erhalt einer in Reaktor C vorhandenen Inertgasatmosphäre, aus Reaktor C entnommen. Dies kann beispielsweise über folgende Austragsverfahren erfolgen: pneumatisch (mittels Über- oder Unterdruck); mechanisch (Zellenradschleuse, Telleraustrag, Austragsschnecke bzw. Rührorgan im Reaktor, Bandaustrag), gravimetrisch (Doppelklappe bzw. -kugelhahn ggf. unterstützt durch Vibration).

Als Silicium-freie Reaktivkomponente sind ein oder mehrere Kohlenwasserstoffe bevorzugt. Durch thermische Zersetzung der Kohlenwasserstoffe kann allgemein Kohlenstoff in Poren und auf der Oberfläche der porösen Partikel abgeschieden werden. Beispiele für Kohlenwasserstoffe sind aliphatische Kohlenwasserstoffe mit 1 bis 10 Kohlenstoffatomen, insbesondere 1 bis 6 Kohlenstoffatomen, vorzugsweise Methan, Ethan, Propan, Butan, Pentan, Isobutan, Hexan, Cyclopropan, Cyclobutan, Cyclopentan, Cyclohexan und Cycloheptan, ungesättigte Kohlenwasserstoffe mit 1 bis 10 Kohlenstoffatomen, wie beispielsweise Ethen, Acetylen, Propen oder Buten, Isopren, Butadien, Divinylbenzol, Vinylacetylen, Cyclohexadien, Cyclooctadien, cyclische ungesättigte Kohlenwasserstoffe, wie beispielsweise Cyclopropen, Cyclobuten, Cyclopenten, Cyclohexen, Cyclohexadien, Cyclopentadien, Dicyclopentadien und Norbornadien, aromatische Kohlenwasserstoffe, wie beispielweise Benzol, Toluol, p-,m-,o-Xylol, Styrol (Vinylbenzol), Ethylbenzol, Diphenylmethan und Naphthalin, weitere aromatische Kohlenwasserstoffe, wie beispielsweise Phenol, o-, m-, p-Kresol, Cymol, Nitrobenzol, Chlorbenzol, Pyridin, Anthracen und Phenanthren, Myrcen, Geraniol, Thioterpineol, Norbornan, Borneol, iso-Borneol, Bornan, Campher, Limonen, Terpinen, Pinen, Pinan, Caren, Phenol, Anilin, Anisol, Furan, Furfural, Furfurylalkohol, Hydroxymethylfurfural, Bishydroxymethylfuran und gemischte Fraktionen, die eine Vielzahl solcher Verbindungen enthalten, wie beispielsweise aus Erdgaskondensaten, Erdöldestillaten oder Koksofenkondensaten, gemischte Fraktionen aus den Produktströmen eines Fluid-Catalytic-Crackers (FCC), Steam-Crackers oder einer Fischer-Tropsch-Syntheseanlage, oder ganz allgemein kohlenwasserstoffhaltige Stoffströme aus der Holz-, Erdgas-, Erdöl- und Kohleverarbeitung.

Die Silicium-freien Reaktivkomponenten, nämlich die Reaktivkomponenten, die ein oder mehrere Kohlenwasserstoffe aber keinen Silicium-Präkursor enthalten, enthalten vorzugsweise keine weitere Komponente oder ein oder mehrere Inertgase und/oder ein oder mehrere reaktive Bestandteile, wie beispielsweise Wasserstoff, und/oder ein oder mehrere Dotierstoffe. Dotierstoffe sind beispielsweise Bor, Stickstoff, Phosphor, Arsen, Germanium, Eisen oder Nickel enthaltende Verbindungen. Die Dotierstoffe werden bevorzugt ausgewählt aus der Gruppe umfassend Ammoniak $NH_3$, Diboran $B_2H_6$, Phosphan $PH_3$, German $GeH_4$, Arsan $AsH_3$ und Nickeltetracarbonyl $Ni(CO)_4$.

Als Reaktoren im Sinne dieser Anmeldung werden bevorzugt Reaktortypen ausgewählt aus der Gruppe umfassend Retortenöfen, Rohrreaktoren, Rührbettreaktoren, Rührkesselreaktoren sowie Autoklaven. Besonders bevorzugt kommen gerührte Reaktoren und Autoklaven, insbesondere bevorzugt gerührte Reaktoren und ganz besonders bevorzugt Rührkesselreaktoren zum Einsatz.

In einer speziellen Variante des Verfahrens sind Reaktor A, B und C das gleiche Gefäß. Es ist nicht ausgeschlossen, dass Reaktor A, B und C dasselbe Gefäß sind. In zwei besonderen Ausführungsformen des Verfahrens besteht der Kaskadenreaktor aus nur zwei voneinander abhängigen Reaktoren. In der ersten Ausführungsform werden die Phasen 1 und 2 im selben Reaktor durchgeführt. In der zweiten Ausführungsform werden die Phasen 2 und 3 in einem Reaktor durchgeführt. In beiden Fällen können die Reaktoren unterschiedliche Temperaturzonen haben, sie können unter Normaldruck als auch im Unter- oder im Überdruck betrieben werden.

Ein Reaktor kann zugleich temperierbar, druckfest und vakuumfest sein, alle Kombinationen sind möglich. Ein Reaktor kann aber auch jeweils nur eines der zuvor genannten Merkmale erfüllen.

Technische Anforderungen an die Reaktoren und optionale Besonderheiten für spezielle Varianten der Erfindung:

Reaktor A:

- Der Reaktor ist mindestens temperierbar.
- Der Reaktor kann vakuumfest sein.
- System zur Vorheizung, Trocknung und Inertisierung der porösen Partikel.
- Es kann ein System zur gezielten Zugabe/Dosierung der porösen Partikel (technische Beschreibung siehe Phase 1) angeschlossen werden.
- Zum Trocknen bzw. Entfernen von Verunreinigungen der porösen Partikel kann ein System angeschlossen werden, das es erlaubt, kondensierbare oder resublimierbare Stoffe zu entfernen.
- Es kann ein System angeschlossen werden, mit dem die porösen Partikel in den Reaktor B überführt werden können (technische Beschreibung siehe Phase 1)

Reaktor B:

- Der Reaktor ist mindestens temperierbar.
- Enthält ein erfindungsgemäßes Rührwerk
- System zur Zudosierung von Reaktionsgas
- System zur Abführung von Reaktionsgas
- Zur Prozessvereinfachung kann ein Wasserstoffabscheider (technische Beschreibung, siehe Phase 2) angeschlossen sein.
- Zur Entfernung von in den gasförmigen Reaktionsprodukten auftretenden, kondensierbaren oder resublimierbaren Nebenprodukten kann ein Behälter angeschlossen werden, der es erlaubt, die Nebenprodukte durch Kondensation oder Resublimation zu entfernen.
- Es kann ein System angeschlossen werden, mit dem das Material in den Reaktor C oder einen Vorratsbehälter überführt werden kann (technische Beschreibung siehe Phase 1).

Reaktor C:

- Der Reaktor ist mindestens temperierbar.
- System zur Entfernung von kondensierbaren oder resublimierbaren Nebenprodukten.
- Es kann ein Behälter angeschlossen werden, der es erlaubt, die Nebenprodukte durch Kondensation oder Resublimation zu entfernen.
- System zur Zudosierung von Reaktionsgas zur Funktionalisierung
- System zur Abführung von Reaktionsgas
- Es kann ein System angeschlossen werden, mit dem das Material in einen Vorratsbehälter überführt werden kann (technische Beschreibung siehe Phase 3).

Ein temperierbarer Reaktor ist allgemein ein Reaktor, der so betrieben werden kann, dass die Temperatur im Inneren des Reaktors beispielweise im Bereich zwischen -40 und 1000 °C eingestellt werden kann. Kleinere Temperaturbereiche sind möglich.

Kaskadenreaktorsystem im Sinne der Anmeldung ist die Verknüpfung von mindestens 2 Reaktoren. Die Anzahl von Reaktoren ist nach oben offen. Die Anzahl der Reaktoren A, B und C zueinander sowie deren Größen, Form, Material und Ausgestaltungen können unterschiedlich sein. Der Fachmann kann die Mengen an Reaktoren und deren Größen aufeinander abstimmen, um insgesamt den Output des Kaskadenreaktorsystems so effizient wie möglich zu gestalten. Die Reaktoren können direkt miteinander verbunden sein oder örtlich voneinander getrennt sein, die Beschickung erfolgt dann mittels beweglichen Vorratsbehältern. Denkbar ist auch, dass mehrere Reaktoren B miteinander verschaltet werden und jeder Reaktionsschritt in einem separaten Reaktor B abläuft.

Die porösen Partikel sowie das entstehende Silicium-enthaltende Material können während des Prozesses allgemein als unbewegte Schüttung oder unter Durchmischung bewegt vorliegen. Eine bewegte Durchmischung der porösen Partikel beziehungsweise des entstehenden Silicium-enthaltenden Materials in Reaktor A, B und C ist bevorzugt. Während der thermischen Zersetzung der Reaktivkomponenten in Phase 2 müssen die Partikel jedoch durchmischt werden. Dadurch kann beispielsweise ein homogener Kontakt aller porösen Partikel mit Reaktivkomponenten oder eine homogene Temperaturverteilung der Schüttung erreicht werden. Die Umwälzung der Partikel kann beispielsweise durch Rühreinbauten im Reaktor oder die Bewegung des gesamten Reaktors um einen Rührer herbeigeführt werden.

Eine weitere bevorzugte Bauform der Reaktoren A, B und C sind feststehende Reaktoren mit sich bewegenden Rührorganen zur Umwälzung. Aufgabe der Umwälzung ist es, den porösen Feststoff möglichst gleichmäßig mit der gasförmigen Reaktivkomponente in Kontakt zu bringen. Bevorzugte Geometrien hierfür sind zylindrische Reaktoren, konische Reaktoren, kugelförmige, polyedrische, rotationssymmetrische Reaktoren oder Kombinationen davon. Die Bewegung des Rührorgans ist bevorzugt eine Rotationsbewegung. Andere Bewegungsformen sind ebenfalls geeignet. Der Antrieb des Rührorgans erfolgt bevorzugt über eine Rührwelle, wobei pro Rührwelle ein Rührorgan oder mehrere Rührorgane vorhanden sein können. In den Reaktoren A, B und C können mehrere Rührwellen eingebracht werden, auf denen jeweils ein Rührorgan oder mehrere Rührorgane vorhanden sein können. Die Hauptreaktorachse ist vorzugsweise horizontal oder vertikal ausgerichtet. Die Rührwellen werden in einer weiteren bevorzugten Ausführungsform horizontal oder vertikal in einen beliebig orientierten Reaktor eingebaut. Für vertikal betriebene Reaktoren A, B und C sind Bauformen bevorzugt, bei denen beispielsweise über eine Hauptrührwelle ein Rührorgan oder mehrere Rührorgane durch eine Rotationsbewegung das Schüttgut durchmischen. Es sind weiterhin Bauformen möglich, bei denen zwei oder mehr Rührwellen parallel laufen. Es sind zudem Bauformen möglich, bei denen zwei oder mehr Rührwellen nicht parallel zueinander betrieben werden. Eine weitere Bauform für einen vertikal betriebenen Reaktor A, B oder C ist durch die Nutzung einer Förderschnecke gekennzeichnet. Die Förderschnecke fördert bevorzugt zentral das Schüttgut. Eine weitere erfindungsgemäße Bauart ist die am Rand des Reaktors entlang rotierende Förderschnecke (Nauta®-Mischer, Hosokawa). Eine weitere bevorzugte Bauform ist ein planetarisches Rührsystem bzw. Spiralrührsystem. Für horizontal betriebene Reaktoren A, B oder C sind Bauformen bevorzugt, bei denen beispielsweise über eine Hauptrührwelle ein Rührorgan oder mehrere Rührorgane durch eine Rotationsbewegung das Schüttgut durchmischen. Es sind auch Bauformen möglich, bei denen zwei oder mehr Rührwellen parallel laufen. Es sind weiterhin Bauformen bevorzugt, bei denen zwei oder mehr Rührwellen nicht parallel zueinander betrieben werden. Für vertikal betriebene Reaktoren A, B oder C sind Rührorgane bevorzugt, ausgewählt aus der Gruppe enthaltend Wendelrührer, Spiralrührer, Ankerrührer oder allgemein Rührorgane, die das Schüttgut axial oder radial oder sowohl axial als auch radial fördern und eine erfindungsgemäße Wandgängigkeit $W$ aufweisen. Bei horizontal betriebenen Reaktoren A, B oder C sind bevorzugt mehrere Rührorgane auf einer Welle vorhanden. Erfindungsgemäße Bauformen für die Rührorgane von horizontal betriebenen Reaktoren sind beispielsweise Pflugschar, Paddel, Blattrührer, Spiralrührer oder allgemein Rührorgane, die das Schüttgut sowohl axial als auch radial fördern und eine erfindungsgemäße Wandgängigkeit $W$ aufweisen. Die Wandgängigkeit kann durch zusätzliche Abschaber am Rührorgan verringert werden. Neben den sich bewegenden Rührorganen sind für den Reaktor A, B oder C auch starre Einbauten, wie Leitbleche, möglich.

Für den Bau von Reaktor A, B oder C für die Durchführung des erfindungsgemäßen Verfahrens ist grundsätzlich jeder Werkstoff geeignet, der bei den jeweiligen Prozessbedingungen die notwendige mechanische Festigkeit und chemische Beständigkeit aufweist. Bezüglich der chemischen Beständigkeit kann der Reaktor A, B oder C sowohl aus entsprechenden Vollmaterialien als auch aus chemisch nicht beständigen Materialien (drucktragend) mit speziellen Beschichtungen oder Plattierungen medienberührter Teile bestehen.

Dabei werden die Materialien erfindungsgemäß ausgewählt aus der Gruppe enthaltend:

- metallische Werkstoffe, die (gemäß DIN CEN ISO/TR 15608) für Stähle den Werkstoffgruppen 1 bis 11, für Nickel und Nickellegierungen den Gruppen 31 bis 38, für Titan und Titanlegierungen den Gruppen 51 bis 54, für Zirkonium und Zirkoniumlegierungen den Gruppen 61 und 62 und für Gusseisen den Gruppen 71 bis 76 entsprechen,
- keramische Werkstoffe aus Oxid-Keramiken im Einstoffsystem, wie beispielsweise Aluminiumoxid, Magnesiumoxid, Zirkoniumoxid, Titandioxid (Kondensatorwerkstoff) sowie Mehrstoffsysteme, wie beispielsweise Aluminiumtitanat (Mischform aus Aluminium- und Titanoxid), Mullit (Mischform aus Aluminium- und Siliciumoxid), Bleizirkonattitanat (Piezokeramik), oder Dispersionskeramiken wie mit Zirkoniumoxid verstärktes Aluminiumoxid (ZTA - Zirconia Toughened Aluminum Oxide) - $Al_2O_3/ZrO_2$),
- Nicht-Oxid-Keramiken, wie beispielsweise Carbide, zum Beispiel Siliciumcarbid und Borcarbid, Nitride, zum Beispiel Siliciumnitrid, Aluminiumnitrid, Bornitrid und Titannitrid, Boride und Silicide sowie deren Mischungen und
- Verbund- bzw. Kompositwerkstoffe, die zu den Gruppen der Teilchenverbundwerkstoffe, wie beispielsweise Hartmetall, Keramikverbunde, Beton und Polymerbeton, der Faserverbundwerkstoffe, wie beispielsweise glasfaserverstärktes Glas, Metallmatrix-Verbunde (MMC), Faserzement, kohlefaserverstärktes Siliciumcarbid, eigenverstärkte Thermoplaste, Stahlbeton, Faserbeton, Faser-Kunststoff-Verbunde, wie beispielsweise kohlenstofffaserverstärkter Kunststoff (CFK), glasfaserverstärkter Kunststoff (GfK) und aramidfaserverstärkter Kunststoff (AFK), Faser-Keramik-Verbunde (Ceramic Matrix Composites (CMC)), der Durchdringungsverbundwerkstoffe, wie beispielsweise Metall-Matrix-Verbunde (MMC), dispersionsverfestigte Aluminiumlegierungen oder dispersionsgehärtete Nickelchrom-Superlegierungen, der Schichtverbundwerkstoffe, wie beispielsweise Bimetalle, Titangraphit-Komposit, Verbundplatten und -rohre, glasfaserverstärktes Aluminium und Sandwich-Konstruktionen, und der Strukturverbundwerkstoffe zählen.

Die porösen Partikel für das erfindungsgemäße Verfahren werden vorzugsweise ausgewählt aus der Gruppe enthaltend amorphen Kohlenstoff in Form von Hardcarbon, Softcarbon, Mesocarbon, Microbeads, Naturgraphit oder synthetischem Graphit, ein- und mehrwandige Kohlenstoffnanoröhren und Graphen, Oxide wie Siliciumdioxid, Aluminiumoxid, Silicium-Aluminium-Mischoxide, Magnesiumoxid, Bleioxide und Zirkonoxid, Carbide wie Siliciumcarbide und Borcarbide, Nitride wie Siliciumnitride und Bornitride; und andere keramische Werkstoffe, wie sie sich durch folgende Komponentenformel beschreiben lassen:

$Al_aB_bC_cMg_dN_eO_fSi_g$ mit $0 \leq a, b, c, d, e, f, g \leq 1$, mit mindestens zwei Koeffizienten a bis g > 0 und $a*3 + b*3 + c*4 + d*2 + g*4 \geq e*3 + f*2$.

Die keramischen Werkstoffe können beispielsweise binäre, ternäre, quaternäre, quinäre, senäre oder septernäre Verbindungen sein. Bevorzugt sind keramische Werkstoffe mit folgenden Komponentenformeln:

Nichtstöchiometrische Bornitride $BN_2$ mit z = 0,2 bis 1,

Nichtstöchiometrische Kohlenstoffnitride $CN_2$ mit z = 0,1 bis 4/3,

Borcarbonitride $B_xCN_z$ mit x = 0,1 bis 20 und z = 0,1 bis 20, wobei gilt $x*3 + 4 \geq z*3$,

Bornitridooxide $BN_zO_r$ mit z = 0,1 bis 1 und r = 0,1 bis 1, wobei gilt $3 \geq r*2 + z*3$,

Borcarbonitridooxide $B_xCN_zO_r$ mit x = 0,1 bis 2, z = 0,1 bis 1 und r = 0,1 bis 1, wobei gilt: $x*3 + 4 \geq r*2 + z*3$,

Siliciumcarbooxide $Si_xCO_z$ mit x = 0,1 bis 2 und z = 0,1 bis 2, wobei gilt $x*4 + 4 \geq z*2$,

Siliciumcarbonitride $Si_xCN_z$ mit x = 0,1 bis 3 und z = 0,1 bis 4, wobei gilt $x*4 + 4 \geq z*3$,

Siliciumborocarbonitride $Si_wB_xCN_z$ mit w = 0,1 bis 3, x = 0,1 bis 2 und z = 0,1 bis 4, wobei gilt $w*4 + x*3 + 4 \geq z*3$,

Siliciumborocarbooxide $Si_wB_xCO_z$ mit w = 0,10 bis 3, x = 0,1 bis 2 und z = 0,1 bis 4, wobei gilt $w*4 + x*3 + 4 \geq z*2$,

Siliciumborocarbonitridooxide $Si_vB_wCN_xO_z$ mit v = 0,1 bis 3, w = 0,1 bis 2, x = 0,1 bis 4 und z = 0,1 bis 3, wobei gilt $v*4 + w*3 + 4 \geq x*3 + z*2$ und

Aluminiumborosilicocarbonitridooxide $Al_uB_vSi_xCN_wO_z$ mit u = 0,1 bis 2, v = 0,1 bis 2, w = 0,1 bis 4, x = 0,1 bis 2 und z = 0,1 bis 3, wobei gilt $u*3 + v*3 + x*4 + 4 \geq w*3 + z*2$.

Bevorzugt besitzen die porösen Partikel eine durch Heliumpyknometrie bestimmte Dichte von 0,1 bis 7 g/cm$^3$ und besonders bevorzugt von 0,3 bis 3 g/cm$^3$. Dies ist vorteilhaft zur Steigerung der volumetrischen Kapazität (mAh/cm$^3$) von Lithium-Ionen-Batterien.

Bevorzugt kommen als poröse Partikel amorphe Kohlenstoffe, Siliciumdioxid, Bornitrid, Siliciumcarbid sowie Siliciumnitrid oder auch Mischwerkstoffe auf Basis dieser Materialien zum Einsatz, besonders bevorzugt ist die Verwendung von amorphen Kohlenstoffen, Bornitrid und Siliciumdioxid.

Die porösen Partikel weisen eine volumengewichtete Partikelgrößenverteilung mit Durchmesser-Perzentilen $d_{50}$ auf von vorzugsweise $\geq 0,5 \mu m$, besonders bevorzugt $\geq 1,5 \mu m$ und am meisten bevorzugt $\geq 2 \mu m$. Die Durchmesser-Perzentile $d_{50}$ sind vorzugsweise $\leq 20 \mu m$, besonders bevorzugt $\leq 12 \mu m$ und am meisten bevorzugt $\leq 8 \mu m$.

Die volumengewichtete Partikelgrößenverteilung der porösen Partikel liegt vorzugsweise zwischen den Durchmesser-Perzentilen $d_{10} \geq 0,2 \mu m$ und $d_{90} \leq 20,0 \mu m$, besonders bevorzugt zwischen $d_{10} \geq 0,4 \mu m$ und $d_{90} \leq 15,0 \mu m$ und am meisten bevorzugt zwischen $d_{10} \geq 0,6 \mu m$ bis $d_{90} \leq 12,0 \mu m$.

Die porösen Partikel haben eine volumengewichtete Partikelgrößenverteilung mit Durchmesser-Perzentilen $d_{10}$ von vorzugsweise $\leq 10 \mu m$, besonders bevorzugt $\leq 5 \mu m$, insbesondere bevorzugt $\leq 3 \mu m$ und am meisten bevorzugt $\leq 2 \mu m$. Die Durchmesser-Perzentile $d_{10}$ sind vorzugsweise $\geq 0,2 \mu m$, besonders bevorzugt $\geq 0,5$ und am meisten bevorzugt $\geq 1 \mu m$.

Die porösen Partikel haben eine volumengewichtete Partikelgrößenverteilung mit Durchmesser-Perzentilen $d_{90}$ von vorzugsweise $\geq 4 \mu m$ und besonders bevorzugt $\geq 8 \mu m$. Die Durchmesser-Perzentile $d_{90}$ sind vorzugsweise $\leq 18 \mu m$, besonders bevorzugt $\leq 15$ und am meisten bevorzugt $\leq 13 \mu m$.

Die volumengewichtete Partikelgrößenverteilung der porösen Partikel hat eine Breite $d_{90}-d_{10}$ von vorzugsweise $\leq 15,0 \mu m$, mehr bevorzugt $\leq 12,0 \mu m$, besonders bevorzugt $\leq 10,0 \mu m$, insbesondere bevorzugt $\leq 8,0 \mu m$ und am meisten bevorzugt $\leq 4,0 \mu m$.

Die volumengewichtete Partikelgrößenverteilung der nach dem erfindungsgemäßen Verfahren herstellbaren Silicium-enthaltenden Materialien hat eine Breite $d_{90}-d_{10}$ von vorzugsweise $\geq 0,6 \mu m$, besonders bevorzugt $\geq 0,8 \mu m$ und am meisten bevorzugt $\geq 1,0 \mu m$.

Die volumengewichtete Partikelgrößenverteilung der porösen Partikel ist bestimmbar nach ISO 13320 mittels statischer Laserstreuung unter Anwendung des Mie-Modells mit dem Messgerät Horiba LA 950 mit Ethanol als Dispergiermedium für die porösen Partikel.

Die porösen Partikel liegen vorzugsweise in Form von vereinzelten Partikeln vor. Die Partikel können beispielsweise isoliert oder agglomeriert vorliegen. Die porösen Partikel sind vorzugsweise nicht aggregiert und vorzugsweise nicht agglomeriert. Aggregiert bedeutet allgemein, dass im Zuge der Herstellung der porösen Partikel zunächst Primärpartikel gebildet werden und zusammenwachsen und/oder Primärpartikel beispielsweise über kovalente Bindungen miteinander verknüpft sind und auf diese Weise Aggregate bilden. Primärpartikel sind allgemein isolierte Partikel. Aggregate oder isolierte Partikel können Agglomerate bilden. Agglomerate sind eine lose Zusammenballung von Aggregaten oder Primärpartikeln, die beispielsweise über Van-der-Waals-Wechselwirkungen oder Wasserstoffbrückenbindungen miteinander verknüpft sind. Agglomerierte Aggregate können nach gängigen Knet- und Dispergierverfahren leicht wieder in Aggregate aufgespalten werden. Aggregate lassen sich mit diesen Verfahren nicht oder nur teilweise in die Primärpartikel zerlegen. Das Vorliegen der porösen Partikel in Form von Aggregaten, Agglomeraten oder isolierten Partikeln kann beispielsweise mittels herkömmlicher Raster-Elektronen-Mikroskopie (REM) sichtbar gemacht werden. Statische Lichtstreuungsmethoden zur Bestimmung der Teilchengrößenverteilungen oder Partikeldurchmessern von Matrixpartikeln können dagegen nicht zwischen Aggregaten oder Agglomeraten unterscheiden.

Die porösen Partikel können eine beliebige Morphologie aufweisen, also beispielsweise splittrig, plattig, sphärisch oder auch nadelförmig sein, wobei splittrige oder sphärische Partikel bevorzugt sind. Die Morphologie kann beispielsweise durch die Sphärizität $\psi$ oder die Sphärizität $S$ charakterisiert werden. Gemäß der Definition von Wadell ist die Sphärizität $\psi$ das Verhältnis aus der Oberfläche einer Kugel gleichen Volumens zur tatsächlichen Oberfläche eines Körpers. Im Falle einer Kugel hat $\psi$ den Wert 1. Nach dieser Definition haben die porösen Partikel für das erfindungsgemäße Verfahren eine Sphärizität $\psi$ von vorzugsweise 0,3 bis 1,0, besonders bevorzugt von 0,5 bis 1,0 und am meisten bevorzugt von 0,65 bis 1,0.

Die Sphärizität $S$ ist das Verhältnis aus dem Umfang eines äquivalenten Kreises mit gleicher Fläche A wie die Projektion des auf eine Fläche projizierten Partikels und dem gemessenen Umfang U dieser Projektion:

$$S = 2\sqrt{\pi A}/U$$. Im Falle eines ideal kreisförmigen Partikels hätte $S$ den Wert 1. Für die porösen Partikel für das erfindungsgemäße Verfahren liegt die Sphärizität $S$ im Bereich von vorzugsweise 0,5 bis 1,0 und besonders bevorzugt von 0,65 bis 1,0, bezogen auf die Perzentile $S_{10}$ bis $S_{90}$ der Sphärizitäts-Anzahlverteilung. Die Messung der Sphärizität $S$ erfolgt beispielsweise anhand von Aufnahmen einzelner Partikel mit einem optischen Mikroskop oder bei Partikeln < 10 $\mu$m bevorzugt mit einem Rasterelektronenmikroskop durch grafische Auswertung mittels einer Bildanalysesoftware, wie beispielsweise ImageJ.

Die porösen Partikel weisen bevorzugt ein gaszugängliches Porenvolumen von $\geq$ 0,2 cm$^3$/g, besonders bevorzugt $\geq$ 0,6 cm$^3$/g und am meisten bevorzugt $\geq$ 1,0 cm$^3$/g auf. Dies ist förderlich, um Lithium-Ionen-Batterien mit hoher Kapazität zu erhalten. Das gaszugängliche Porenvolumen wurde durch Gassorptionsmessungen mit Stickstoff gemäß DIN 66134 bestimmt.

Die porösen Partikel sind vorzugsweise offenporig. Offenporig bedeutet allgemein, dass Poren mit der Oberfläche von Partikeln verbunden sind, beispielsweise über Kanäle, und vorzugsweise mit der Umgebung in stofflichem Austausch, insbesondere in Austausch von gasförmigen Verbindungen, stehen können. Dies lässt sich anhand von Gassorptionsmessungen (Auswertung nach Brunauer, Emmett und Teller, "BET"), also der spezifischen Oberfläche nachweisen. Die porösen Partikel weisen spezifische Oberflächen von bevorzugt $\geq$ 50 m$^2$/g, besonders bevorzugt $\geq$ 500 m$^2$/g und am meisten bevorzugt $\geq$ 1000 m$^2$/g auf. Die BET-Oberfläche wird gemäß DIN 66131 (mit Stickstoff) bestimmt.

Die Poren der porösen Partikel können beliebige Durchmesser aufweisen, also allgemein im Bereich von Makroporen (oberhalb von 50 nm), Mesoporen (2 - 50 nm) und Mikroporen (kleiner 2 nm) liegen. Die porösen Partikel können in beliebigen Mischungen verschiedener Porentypen eingesetzt werden. Bevorzugt werden poröse Partikel mit weniger als 30% Makroporen, bezogen auf das Gesamtporenvolumen, besonders bevorzugt poröse Partikel ohne Makroporen und ganz besonders bevorzugt poröse Partikel mit zumindest 50% Poren mit einem mittleren Porendurchmesser unter 5 nm eingesetzt. Ganz besonders bevorzugt weisen die porösen Partikel ausschließlich Poren mit einem Porendurchmesser kleiner 2 nm auf (Bestimmungsmethode: Porengrößenverteilung nach BJH (Gasadsorption) gemäß DIN 66134 im Mesoporenbereich und nach Horvath-Kawazoe (Gasadsorption) gemäß DIN 66135 im Mikroporenbereich; die Bewertung der Porengrößenverteilung im Makroporen-Bereich erfolgt durch Quecksilberporosimetrie nach DIN ISO 15901-1).

Bevorzugt sind poröse Partikel mit gasunzugänglichem Porenvolumen von kleiner 0,3 cm$^3$/g und besonders bevorzugt kleiner 0,15 cm$^3$/g. Auch damit kann die Kapazität der Lithium-Ionen-Batterien gesteigert werden. Das gasunzugängliche Porenvolumen kann mittels der folgenden Formel bestimmt werden:
Gasunzugängliches Porenvolumen = 1/Reinmaterialdichte - 1/Skelettdichte.

Dabei ist die Reinmaterialdichte eine theoretische Dichte der porösen Partikel, basierend auf der Phasenzusammensetzung oder der Dichte des Reinstoffes (Dichte des Materials als hätte es keine geschlossene Porosität). Daten zu Reinmaterialdichten lassen sich durch den Fachmann beispielsweise dem Ceramic Data Portal des National Institute of Standards entnehmen (NIST, https://srdata.nist.gov/CeramicDataPortal/scd). Beispielsweise beträgt die Reinmaterialdichte von Siliciumoxid 2,203 g/cm$^3$, die von Bornitrid beträgt 2,25 g cm$^3$, die von Siliciumnitrid beträgt 3,44 g/cm$^3$ und die von Siliciumcarbid beträgt 3,21 g/cm$^3$. Die Skelettdichte ist die tatsächliche, durch Heliumpyknometrie bestimmte Dichte der porösen Partikel (Gas-zugänglich).

Klarstellend sei angemerkt, dass die porösen Partikel vom Silicium-enthaltenden Material verschieden sind. Die porösen Partikel fungieren als Startmaterial zur Herstellung des Silicium-enthaltenden Materials. Vorzugsweise befindet sich in den Poren der porösen Partikel und auf der Oberfläche der porösen Partikel allgemein kein Silicium, insbesondere kein Silicium, das durch Abscheiden von Silicium-Präkursoren erhalten wird.

Das mittels Abscheidung von Silicium in Poren und auf der Oberfläche der porösen Partikel nach dem erfindungsgemäßen Verfahren erhältliche Silicium-enthaltende Material weist eine volumengewichtete Partikelgrößenverteilung mit Durchmesser-Perzentilen $d_{50}$ vorzugsweise in einem Bereich von 0,5 bis 20 μm auf. Bevorzugt beträgt der $d_{50}$-Wert zumindest 1,5 μm, und besonders bevorzugt zumindest 2 μm. Die Durchmesser-Perzentile $d_{50}$ betragen vorzugsweise höchstens 13 μm und besonders bevorzugt höchstens 8 μm.

Die volumengewichtete Partikelgrößenverteilung des Silicium-enthaltenden Materials liegt vorzugsweise zwischen den Durchmesser-Perzentilen $d_{10} \geq 0,2$ μm und $d_{90} \leq 20,0$ μm, besonders bevorzugt zwischen $d_{10} \geq 0,4$ μm und $d_{90} \leq 15,0$ μm und am meisten bevorzugt zwischen $d_{10} \geq 0,6$ μm bis $d_{90} \leq 12,0$ μm.

Das Silicium-enthaltende Material hat eine volumengewichtete Partikelgrößenverteilung mit Durchmesser-Perzentilen $d_{10}$ von vorzugsweise $\leq 10$ μm, besonders bevorzugt $\leq 5$ μm, insbesondere bevorzugt $\leq 3$ μm und am meisten bevorzugt $\leq 1$ μm. Die Durchmesser-Perzentile $d_{10}$ sind vorzugsweise $\geq 0,2$ μm, besonders bevorzugt $\geq 0,4$ μm und am meisten bevorzugt $\geq 0,6$ μm.

Das Silicium-enthaltende Material hat eine volumengewichtete Partikelgrößenverteilung mit Durchmesser-Perzentilen $d_{90}$ von vorzugsweise $\geq 5$ μm und besonders bevorzugt $\geq 10$ μm. Die Durchmesser-Perzentile $d_{90}$ sind vorzugsweise $\leq 20$ μm, besonders bevorzugt $\leq 15$ μm und am meisten bevorzugt $\leq 12$ μm.

Die volumengewichtete Partikelgrößenverteilung des Silicium-enthaltenden Materials hat eine Breite $d_{90}$-$d_{10}$ von vorzugsweise $\leq 15,0$ μm, besonders bevorzugt $\leq 12,0$ μm, mehr bevorzugt $\leq 10,0$ μm, insbesondere bevorzugt $\leq 8,0$ μm und am meisten bevorzugt $\leq 4,0$ μm. Die volumengewichtete Partikelgrößenverteilung des Silicium-enthaltenden Materials hat eine Breite $d_{90}$-$d_{10}$ von vorzugsweise $\geq 0,6$ μm, besonders bevorzugt $\geq 0,8$ μm und am meisten bevorzugt $\geq 1,0$ μm.

Die Partikel des Silicium-enthaltenden Materials liegt vorzugsweise in Form von Partikeln vor. Die Partikel können isoliert oder agglomeriert vorliegen. Das Silicium-enthaltende Material ist vorzugsweise nicht aggregiert und vorzugsweise nicht agglomeriert. Die Begriffe isoliert, agglomeriert und nicht aggregiert sind weiter oben in Bezug auf die porösen Partikel schon definiert. Das Vorliegen von Silicium-enthaltenden Materialien in Form von Aggregaten oder Agglomeraten kann beispielsweise mittels herkömmlicher Raster-Elektronen-Mikroskopie (REM) sichtbar gemacht werden.

Das Silicium-enthaltende Material kann eine beliebige Morphologie aufweisen, also beispielsweise splittrig, plattig, sphärisch oder auch nadelförmig sein, wobei splittrige oder sphärische Partikel bevorzugt sind.

Gemäß der Definition von Wadell ist die Sphärizität $\psi$ das Verhältnis aus der Oberfläche einer Kugel gleichen Volumens zur tatsächlichen Oberfläche eines Körpers. Im Falle einer Kugel hat $\psi$ den Wert 1. Nach dieser Definition haben die nach dem erfindungsgemäßen Verfahren zugänglichen Silicium-enthaltenden Materialien eine Sphärizität $\psi$ von vorzugsweise 0,3 bis 1,0 besonders bevorzugt von 0,5 bis 1,0 und am meisten bevorzugt von 0,65 bis 1,0.

Die Sphärizität $S$ ist das Verhältnis aus dem Umfang eines äquivalenten Kreises mit gleicher Fläche A wie die Projektion des auf eine Fläche projizierten Partikels und dem gemessenen Umfang U dieser Projektion:

$$S = 2\sqrt{\pi A}/U$$

. Im Falle eines ideal kreisförmigen Partikels hätte $S$ den Wert 1. Für die nach dem erfindungsgemäßen Verfahren zugänglichen Silicium-enthaltenden Materialien liegt die Sphärizität $S$ im Bereich von vorzugsweise 0,5 bis 1,0 und besonders bevorzugt von 0,65 bis 1,0, bezogen auf die Perzentile $S_{10}$ bis $S_{90}$ der Sphärizitäts-Anzahlverteilung. Die Messung der Sphärizität $S$ erfolgt beispielsweise anhand von Aufnahmen einzelner Partikel mit einem optischen Mikroskop oder bei Partikeln kleiner 10 μm bevorzugt mit einem Rasterelektronenmikroskop durch grafische Auswertung mittels einer Bildanalysesoftware, wie beispielsweise ImageJ.

Über die Morphologie, die materielle Zusammensetzung, insbesondere der spezifischen Oberfläche oder der inneren Porosität des Silicium-enthaltenden Materials kann die Zyklisierungsstabilität von Lithium-Ionen-Batterien weiter gesteigert werden.

Das Silicium-enthaltende Material enthält bevorzugt 10 bis 90 Gew.-%, mehr bevorzugt 20 bis 80 Gew.-%, besonders bevorzugt 30 bis 60 Gew.-% und insbesondere bevorzugt 40 bis 50 Gew.-% an porösen Partikeln, bezogen auf das Gesamtgewicht des Silicium-enthaltenden Materials.

Das Silicium-enthaltende Material enthält bevorzugt 10 bis 90 Gew.-%, mehr bevorzugt 20 bis 80 Gew.-%, besonders bevorzugt 30 bis 60 Gew.-% und insbesondere bevorzugt 40 bis 50 Gew.-% über die Abscheidung aus dem Silicium-Präkursor erhaltenes Silicium, bezogen auf das Gesamtgewicht des Silicium-enthaltenden Materials (Bestimmung vorzugsweise mittels Elementaranalyse, wie ICP-OES).

Falls die porösen Partikel Siliciumverbindungen enthalten, beispielsweise in Form von Siliciumdioxid, lassen sich die vorgenannten Gew.-% Angaben für das über die Abscheidung aus dem Silicium-Präkursor erhaltene Silicium bestimmen, indem die mittels Elementaranalyse ermittelte Siliciummasse der porösen Partikel von der mittels Elementaranalyse ermittelten Siliciummasse des Silicium-enthaltenden Materials subtrahiert wird und das Ergebnis durch die Masse des Silicium-enthaltenden Materials dividiert wird.

Das Volumen des in porösen Partikeln abgeschiedenen Siliciums ergibt sich aus dem Massenanteil des über die Abscheidung aus dem Silicium-Präkursor erhaltenen Siliciums an der Gesamtmasse des Silicium-enthaltenden Materials dividiert durch die Dichte von Silicium ($2{,}336 \text{ g/cm}^3$).

Das Porenvolumen P der Silicium-enthaltenden Materialien ergibt sich aus der Summe von gaszugänglichem und gasunzugänglichem Porenvolumen. Das gaszugängliche Porenvolumen nach Gurwitsch des Silicium-enthaltenden Materials ist bestimmbar durch Gassorptionsmessungen mit Stickstoff nach DIN 66134.

Das gasunzugängliche Porenvolumen des Silicium-enthaltenden Materials ist bestimmbar mit der Formel:

Gasunzugängliches Porenvolumen =1/Skelettdichte -1/Rein- materialdichte.

Dabei ist die Reinmaterialdichte eines Silicium-enthaltenden Materials eine theoretische Dichte, die sich aus der Summe der theoretischen Reinmaterialdichten der im Silicium-enthaltenden Material enthaltenen Komponenten, multipliziert mit ihrem jeweiligen gewichtsbezogenen prozentualen Anteil am Gesamtmaterial, berechnen lässt. Beispielsweise ergibt sich damit für ein Silicium-enthaltendes Material, bei dem Silicium auf einem porösen Partikel abgeschieden wird:

Reinmaterialdichte = theoretische Reinmaterialdichte des Siliciums * Anteil des Siliciums in Gew.-% + theoretische Reinmaterialdichte der porösen Partikel * Anteil der porösen Partikel in Gew.-%.

Daten zu Reinmaterialdichten lassen sich durch den Fachmann beispielsweise dem Ceramic Data Portal des National Institute of Standards entnehmen (NIST, https://srdata.nist.gov/CeramicDataPortal/scd). Beispielsweise beträgt die Reinmaterialdichte von Siliciumoxid $2{,}203 \text{ g/cm}^3$, die von Bornitrid beträgt $2{,}25 \text{ g cm}^3$, die von Siliciumnitrid beträgt $3{,}44 \text{ g/cm}^3$ und die von Siliciumcarbid beträgt $3{,}21 \text{ g/cm}^3$.

Das Porenvolumen P der Silicium-enthaltenden Materialien liegt bevorzugt im Bereich von 0 bis 400 Vol.-%, besonders bevorzugt im Bereich von 100 bis 350 Vol.-% und insbesondere bevorzugt im Bereich von 200 bis 350 Vol.-%, bezogen auf das Volumen des im Silicium-enthaltenden Material enthaltenen, aus der Abscheidung aus dem Silicium-Präkursor erhaltenen Siliciums.

Die im Silicium-enthaltenden Material enthaltene Porosität kann sowohl gaszugänglich als auch gasunzugänglich sein. Das Verhältnis des Volumens von gaszugänglicher zu gasunzugänglicher Porosität des Silicium-enthaltenden Materials kann generell im Bereich von 0 (keine gaszugänglichen Poren) bis 1 (alle Poren sind gaszugänglich) liegen. Bevorzugt liegt das Verhältnis des Volumens von gaszugänglicher zu gasunzugänglicher Porosität des Silicium-enthaltenden Materials im Bereich von 0 bis 0,8, besonders bevorzugt im Bereich von 0 bis 0,3 und insbesondere bevorzugt von 0 bis 0,1.

Die Poren des Silicium-enthaltenden Materials können beliebige Durchmesser aufweisen, beispielsweise im Bereich von Makroporen (> 50 nm), Mesoporen (2-50 nm) und Mikroporen (< 2 nm) liegen. Das Silicium-enthaltende Material kann auch beliebige Mischungen verschiedener Porentypen enthalten. Bevorzugt enthält das Silicium-enthaltende Material höchstens 30% Makroporen, bezogen auf das Gesamtporenvolumen, besonders bevorzugt ist ein Silicium-enthaltendes Material ohne Makroporen und ganz besonders bevorzugt ist ein Silicium-enthaltendes Material mit mindestens 50% Poren, bezogen auf das Gesamtporenvolumen mit einem mittleren Porendurchmesser unter 5 nm. Insbesondere bevorzugt weist das Silicium-enthaltende Material ausschließlich Poren mit einem Durchmesser von höchstens 2 nm auf.

Das Silicium-enthaltende Material weist Siliciumstrukturen auf, die in mindestens einer Dimension Strukturgrößen von bevorzugt höchstens 1000 nm, mehr bevorzugt kleiner 100 nm, besonders bevorzugt kleiner 5 nm (Bestimmungsmethode: Raster-Elektronen-Mikroskopie (REM) und/oder High-Resolution-Transmissions-Electron-Microscopy (HR-TEM)) aufweisen.

Bevorzugt enthält das Silicium-enthaltende Material Siliciumschichten mit einer Schichtdicke unterhalb von 1000 nm, mehr bevorzugt kleiner 100 nm, besonders bevorzugt kleiner 5 nm (Bestimmungsmethode: Raster-Elektronen-Mikroskopie (REM) und/oder High-Resolution-Transmissions-Electron-Microscopy (HR-TEM)). Das Silicium-enthaltende Material kann auch Silicium in Form von Partikeln enthalten. Siliciumpartikel haben einen Durchmesser von bevorzugt höchstens 1000 nm, mehr bevorzugt kleiner 100 nm, besonders bevorzugt kleiner 5 nm (Bestimmungsmethode: Raster-Elektronen-Mikroskopie (REM) und/oder High-Resolution-Transmissions-Electron-Microscopy (HR-TEM)). Die Angabe zu den Siliciumpartikeln bezieht sich hierbei vorzugsweise auf den Durchmesser des Umkreises der Partikel im Mikroskopbild.

Das Silicium-enthaltende Material hat bevorzugt eine spezifische Oberfläche von höchstens $100 \text{ m}^2/\text{g}$, besonders bevorzugt kleiner $30 \text{ m}^2/\text{g}$, und insbesondere bevorzugt kleiner $10 \text{ m}^2/\text{g}$. Die BET-Oberfläche wird gemäß DIN 66131 (mit Stickstoff) bestimmt. Damit kann bei Einsatz des Silicium-enthaltenden Materials als Aktivmaterial in Anoden für Lithium-Ionen-Batterien die SEI-Bildung reduziert und die initiale Couloumb-Effizienz gesteigert werden.

Ferner kann das aus dem Silicium-Präkursor abgeschiedene Silicium im Silicium-enthaltenden Material Dotierstoffe enthalten, beispielsweise ausgewählt aus der Gruppe enthaltend Li, Fe, Al, Cu, Ca, K, Na, S, Cl, Zr, Ti, Pt, Ni, Cr, Sn, Mg, Ag, Co, Zn, B, P, Sb, Pb, Ge, Bi, seltene Erden oder Kombinationen daraus. Bevorzugt sind dabei Lithium und/oder Zinn. Der Gehalt an Dotierstoffen im Silicium-enthaltenden Material ist bevorzugt höchstens 1 Gew.-% und besonders bevorzugt höchstens 100 ppm, bezogen auf das Gesamtgewicht des Silicium-enthaltenden Materials, bestimmbar mittels ICP-OES.

Das Silicium-enthaltende Material weist allgemein eine überraschend hohe Stabilität bei Druckbelastung und/oder Scher-belastung auf. Die Druckstabilität und die Scherstabilität des Silicium-enthaltenden Materials zeigt sich dabei beispielsweise dadurch, dass das Silicium-enthaltende Material bei Druck-(beispielsweise bei der Elektrodenverdichtung) beziehungsweise Scher-Belastung (beispielsweise bei der Elektrodenpräparation) keine oder nur geringfügige Änderungen ihrer porösen Struktur im REM aufweist.

Das Silicium-enthaltende Material kann gegebenenfalls zusätzliche Elemente, wie Kohlenstoff, enthalten. Bevorzugt ist Kohlenstoff in Form von dünnen Schichten mit einer Schichtdicke von höchstens 1 $\mu$m, bevorzugt kleiner 100 nm, besonders bevorzugt kleiner 5 nm und ganz besonders bevorzugt kleiner 1 nm enthalten (bestimmbar über REM bzw. HR-TEM). Die Kohlenstoffschichten können dabei sowohl in den Poren als auch auf der Oberfläche des Silicium-enthaltenden Materials vorhanden sein. Auch die Reihenfolge verschiedener Schichten im Silicium-enthaltenden Material durch entsprechende Wiederholungen der abwechselnden Dosierung unterschiedlicher Präkursoren sowie deren Anzahl ist beliebig. So kann auf den porösen Partikeln zunächst eine Schicht eines weiteren, von den porösen Partikeln unterschiedlichen Materials, wie beispielsweise Kohlenstoff, vorhanden sein und darauf eine Siliciumschicht oder eine Schicht von Siliciumpartikeln zugegen sein. Auch kann auf der Siliciumschicht oder auf der Schicht von Siliciumpartikeln wiederum eine Schicht eines weiteren Materials vorhanden sein, welches vom Material der porösen Partikel verschieden oder gleich diesem sein kann, unabhängig davon, ob zwischen den porösen Partikeln und der Siliciumschicht oder der aus Siliciumpartikeln bestehenden Schicht eine weitere Schicht eines von dem Material der porösen Partikel unterschiedlichen Materials vorhanden ist.

Das Silicium-enthaltende Material enthält vorzugsweise ≤ 50 Gew.-%, besonders bevorzugt ≤ 40 Gew.-% und insbesondere bevorzugt ≤ 20 Gew.-% an zusätzlichen Elementen. Das Silicium-enthaltende Material enthält vorzugsweise ≥ 1 Gew.-%, besonders bevorzugt ≥ 3 Gew.-% und insbesondere bevorzugt ≥ 2 Gew.-% an zusätzlichen Elementen. Die Angaben in Gew.-% beziehen sich auf das Gesamtgewicht des Silicium-enthaltenden Materials. In einer alternativen Ausführungsform enthält das Silicium-enthaltende Material keine zusätzlichen Elemente.

Ferner offenbart ist die Verwendung des Silicium-enthaltenden Materials als Aktivmaterial in Anodenmaterialien für Anoden von Lithium-Ionen-Batterien sowie die Verwendung solcher Anoden zur Herstellung von Lithium-Ionen-Batterien.

Das Anodenmaterial basiert vorzugsweise auf einer Mischung umfassend das nach dem erfindungsgemäßen Verfahren zugängliche geätzte Silicium-enthaltende Material, ein oder mehrere Bindemittel, gegebenenfalls Graphit als weiteres Aktivmaterial, gegebenenfalls ein oder mehrere weitere elektrisch leitende Komponenten und gegebenenfalls ein oder mehrere Additive.

Durch Einsatz von weiteren elektrisch leitenden Komponenten im Anodenmaterial können die Übergangswiderstände innerhalb der Elektrode sowie zwischen Elektrode und Stromableiter reduziert werden, was die Strombelastbarkeit der erfindungsgemäßen Lithium-Ionen-Batterie verbessert. Bevorzugte weitere elektrisch leitende Komponenten sind beispielsweise Leitruß, Kohlenstoff-Nanoröhrchen oder metallische Partikel, wie beispielsweise Kupfer.

Das Anodenmaterial enthält vorzugsweise 0 bis 95 Gew.-%, besonders bevorzugt 0 bis 40 Gew.-% und am meisten bevorzugt 0 bis 25 Gew.-% an einer oder mehreren weiteren elektrisch leitenden Komponenten, bezogen auf das Gesamtgewicht des Anodenmaterials.

Das geätzte Silicium-enthaltende Material kann in den Anoden für Lithium-Ionen-Batterien zu vorzugsweise 5 bis 100 Gew.-%, besonders bevorzugt 30 bis 100 Gew.-% und am meisten bevorzugt 60 bis 100 Gew.-%, bezogen auf das gesamte im Anodenmaterial enthaltene Aktivmaterial enthalten sein.

Bevorzugte Bindemittel sind Polyacrylsäure oder deren Alkali-, insbesondere Lithium- oder Natrium-Salze, Polyvinylalkohole, Cellulose oder Cellulosederivate, Polyvinylidenfluorid, Polytetrafluorethylen, Polyolefine, Polyimide, insbesondere Polyamidimide, oder thermoplastische Elastomere, insbesondere Ethylen-Propylen-Dien-Terpolymere. Besonders bevorzugt sind auch die Alkali-, insbesondere Lithium- oder Natrium-Salze, der vorgenannten Bindemittel. Es können sämtliche oder vorzugsweise ein Anteil der Säure-Gruppen eines Bindemittels in Form von Salzen vorliegen. Die Bindemittel haben eine Molmasse von vorzugsweise 100.000 bis 1.000.000 g/mol. Es können auch Gemische von zwei oder mehr Bindemitteln eingesetzt werden.

Als Graphit kann allgemein natürlicher oder synthetischer Graphit eingesetzt werden. Die Graphitpartikel haben bevorzugt eine volumengewichtete Partikelgrößenverteilung zwischen den Durchmesser-Perzentilen $d_{10} > 0,2$ $\mu$m und $d_{90} < 200$ $\mu$m.

Beispiele für Additive sind Porenbildner, Dispergiermittel, Verlaufsmittel oder Dotiermittel, beispielsweise elementares Lithium.

Bevorzugte Rezepturen für das Anodenmaterial enthalten vorzugsweise 5 bis 95 Gew.-% des Silicium-enthaltenden Materials, 0 bis 90 Gew.-% weitere elektrisch leitende Komponenten, 0 bis 90 Gew.-% Graphit, 0 bis 25 Gew.-% Bindemittel und 0 bis 80 Gew.-% Additive, wobei sich die Angaben in Gew.-% auf das Gesamtge wicht des Anodenmaterials beziehen und sich die Anteile aller Bestandteile des Anodenmaterials auf 100 Gew.-% aufsummieren.

Die Verarbeitung der Bestandteile des Anodenmaterials zu einer Anodentinte bzw. -paste erfolgt bevorzugt in einem Lösungsmittel, vorzugsweise ausgewählt aus der Gruppe umfassend Wasser, Hexan, Toluol, Tetrahydrofuran, N-Methylpyrrolidon, N-Ethylpyrrolidon, Aceton, Ethylacetat, Dimethylsulfoxid, Dimethylacetamid und Ethanol sowie Gemischen dieser Lösungsmittel, vorzugsweise unter Verwendung von Rotor-Stator-Maschinen, Hochenergiemühlen, Planetenknetern, Rührwerkskugelmühlen, Rüttelplatten oder Ultraschallgeräten.

Die Anodentinte bzw. -paste weist einen pH-Wert von vorzugsweise 2 bis 8,5 (bestimmt bei 20°C, beispielsweise mit dem pH-Meter von WTW pH 340i mit Sonde SenTix RJD) auf.

Die Anodentinte oder -paste kann beispielsweise auf eine Kupferfolie oder einen anderen Stromsammler aufgerakelt werden. Andere Beschichtungsverfahren, wie beispielsweise Rotationsbeschichtung (Spin-Coating), Rollen-, Tauch- oder Schlitzdüsenbeschichtung, Streichen oder Sprühen, können ebenso erfindungsgemäß verwendet werden.

Vor dem Beschichten der Kupferfolie mit dem erfindungsgemäßen Anodenmaterial kann eine Behandlung der Kupferfolie mit einem handelsüblichen Primer, beispielsweise auf der Basis von Polymerharzen oder Silanen, erfolgen. Primer können zu einer Verbesserung der Haftung auf dem Kupfer führen, besitzen aber selbst im Allgemeinen praktisch keine elektrochemische Aktivität.

Das Anodenmaterial wird im Allgemeinen bis zur Gewichtskonstanz getrocknet. Die Trocknungstemperatur richtet sich nach den eingesetzten Komponenten und dem verwendeten Lösungsmittel. Sie liegt bevorzugt zwischen 20 und 300°C. Die Schichtdicke, das heißt die Trockenschichtdicke der Anodenbeschichtung, ist bevorzugt 2 bis 500 $\mu$m.

Abschließend können die Elektrodenbeschichtungen kalandriert werden, um eine definierte Porosität einzustellen. Die so hergestellten Elektroden weisen bevorzugt Porositäten von 15 bis 85% auf, welche über Quecksilberporosimetrie nach DIN ISO 15901-1 bestimmt werden können. Dabei werden bevorzugt 25 bis 85% des so bestimmbaren Porenvolumens durch Poren bereitgestellt, welche einen Porendurchmesser von 0,01 bis 2 $\mu$m aufweisen.

Ferner offenbart sind Lithium-Ionen-Batterien umfassend eine Kathode, eine Anode, die das geätzte Silicium-enthaltende Material enthält, zwei elektrisch leitende Anschlüsse an den Elektroden, einen Separator und einen Elektrolyten, mit dem der Separator und die beiden Elektroden getränkt sind, sowie ein die genannten Teile aufnehmendes Gehäuse.

In Sinne dieser Erfindung umfasst der Begriff Lithium-Ionen-Batterie auch Zellen. Zellen umfassen allgemein eine Kathode, eine Anode, einen Separator und einen Elektrolyten. Lithium-Ionen-Batterien enthalten neben einer oder mehreren Zellen vorzugsweise zusätzlich ein Batteriemanagementsystem. Batteriemanagementsysteme dienen allgemein zur Steuerung von Batterien, beispielsweise mittels elektronischer Schaltungen, insbesondere zur Erkennung des Ladezustands, für den Tiefentladeschutz oder Überladeschutz.

Als bevorzugte Kathodenmaterialien können Lithiumcobaltoxid, Lithiumnickeloxid, Lithiumnickelcobaltoxid (dotiert oder nicht dotiert), Lithiummanganoxid (Spinell), Lithiumnickelcobaltmanganoxide, Lithiumnickelmanganoxide, Lithiumeisenphosphat, Lithiumcobaltphosphat, Lithiummanganphosphat, Lithiumvanadiumphosphat, oder Lithiumvanadiumoxide erfindungsgemäß eingesetzt werden.

Der Separator ist im Allgemeinen eine elektrisch isolierende, für Ionen durchlässige Membran, bevorzugt aus Polyolefinen, beispielsweise Polyethylen (PE) oder Polypropylen (PP), oder Polyester bzw. entsprechenden Laminaten. Der Separator kann, wie in der Batterieherstellung gebräuchlich, alternativ aus Glas- oder Keramikmaterialien bestehen oder damit beschichtet sein. Der Separator trennt bekanntermaßen die erste Elektrode von der zweiten Elektrode und verhindert somit elektronisch leitende Verbindungen zwischen den Elektroden (Kurzschluss).

Der Elektrolyt ist vorzugsweise eine Lösung enthaltend ein oder mehrere Lithiumsalze (= Leitsalz) in einem aprotischen Lösungsmittel. Bevorzugt sind Leitsalze ausgewählt aus der Gruppe enthaltend Lithiumhexafluorophosphat, Lithiumhexafluoroarsenat, Lithiumperchlorat, Lithiumtetrafluoroborat, Lithiumimide, Lithiummethide, Lithiumtrifluoromethansulfonat $LiCF_3SO_3$, Lithiumbis(trifluoromethansulfonimid) $LiN(CF_3SO_2)_2$ und Lithiumborate. Die Konzentration des Leitsalzes, bezogen auf das Lösungsmittel, liegt vorzugsweise zwischen 0,5 mol/l und der Löslichkeitsgrenze des entsprechenden Salzes. Besonders bevorzugt beträgt sie 0,8 bis 1,2 mol/l.

Als Lösungsmittel werden bevorzugt cyclische Carbonate, Propylencarbonat, Ethylencarbonat, Fluorethylencarbonat, Dimethylcarbonat, Diethylcarbonat, Ethylmethylcarbonat, Dimethoxyethan, Diethoxyethan, Tetrahydrofuran, 2-Methyltetrahydrofuran, gamma-Butyrolacton, Dioxolan, Acetonitril, organische Kohlensäureester oder Nitrile, einzeln oder als Mischungen daraus, eingesetzt.

Bevorzugt enthält der Elektrolyt einen Filmbildner, wie beispielsweise Vinylencarbonat oder Fluorethylencarbonat. Dadurch kann eine signifikante Verbesserung der Zyklenfestigkeit der Anoden enthaltend das nach dem erfindungsgemäßen Verfahren erhaltene geätzte Silicium-enthaltende Material erreicht werden. Dies wird hauptsächlich der Bildung einer festen Elektrolytzwischenphase auf der Oberfläche von aktiven Partikeln zugeschrieben. Der Anteil des Filmbildners im Elektrolyten beträgt bevorzugt zwischen 0,1 und 20,0 Gew.-%.

Um die faktischen Kapazitäten der Elektroden einer Lithium-Ionen-Zelle möglichst optimal aufeinander abzustimmen, ist es vorteilhaft, die Materialien für die positive und negative Elektrode bezüglich ihrer absoluten Kapazität auszubalancieren. Von besonderer Bedeutung ist in diesem Zusammenhang, dass es beim ersten bzw. initialen Lade-/Entladezyklus von sekundären Lithium-Ionen-Zellen (der sogenannten Formierung) zur Ausbildung einer Deckschicht auf der Oberfläche der elektrochemisch aktiven Materialien in der Anode kommt. Diese Deckschicht wird als "Solid Elektrolyte Interphase" (SEI) bezeichnet und besteht in der Regel vor allem aus Elektrolytzersetzungsprodukten sowie einer gewissen Menge an Lithium, das entsprechend für weitere Lade-/Entladereaktionen nicht mehr zur Verfügung steht. Die Dicke und Zusammensetzung der SEI ist abhängig von der Art und der Qualität des verwendeten Anodenmaterials und der verwendeten Elektrolytlösung.

Die SEI ist im Falle von Graphit besonders dünn. Auf Graphit kommt es im ersten Ladeschritt zu einem Verlust von üblicherweise 5 bis 35% des mobilen Lithiums. Dementsprechend sinkt auch die reversible Kapazität der Batterie.

Bei Anoden mit dem nach dem erfindungsgemäßen Verfahren erhaltenen geätzten Silicium-enthaltenden Aktivmaterial kommt es im ersten Ladeschritt zu einem Verlust an mobilem Lithium von vorzugsweise höchstens 30%, besonders bevorzugt höchstens 20% und am meisten bevorzugt höchstens 10%, was deutlich unter den im Stand der Technik, wie beispielsweise in der US 10,147,950 B1, beschriebenen Werten liegt.

Alle zur Herstellung solcher Lithium-Ionen-Batterien, wie oben beschrieben, benutzten Stoffe und Materialien sind bekannt. Die Herstellung der Teile derartiger Batterien und ihre Zusammenfügung zu Batterien erfolgt nach den auf dem Gebiet der Batterieherstellung bekannten Verfahren.

Das nach dem erfindungsgemäßen Verfahren erhaltene Silicium-enthaltende Material zeichnet sich durch ein deutlich verbessertes elektrochemisches Verhalten aus und führt zu Lithium-Ionen-Batterien mit hohen volumetrischen Kapazitäten und hervorragenden Anwendungseigenschaften. Das nach dem erfindungsgemäßen Verfahren erhaltene Silicium-enthaltende Material ist permeabel für Lithium-Ionen sowie Elektronen und ermöglicht somit den Ladungstransport. Die SEI in Lithium-Ionen-Batterien kann mit dem nach dem erfindungsgemäßen Verfahren erhaltenen Silicium-enthaltenden Material in großem Umfang reduziert werden. Zusätzlich löst sich die SEI auf Grund des Designs des nach dem erfindungsgemäßen Verfahren erhaltenen Silicium-enthaltenden Materials nicht mehr oder zumindest in weit geringerem Umfang von der Oberfläche des Aktivmaterials ab. All dies führt zu einer hohen Zyklenbeständigkeit entsprechender Lithium-Ionen-Batterien, in deren Anoden das nach dem erfindungsgemäßen Verfahren erhältliche Silicium-enthaltende Material enthalten ist.

Die nachfolgenden Beispiele dienen zur weiteren Erläuterung der hier beschriebenen Erfindung.

Folgende analytische Methoden und Geräte wurden zur Charakterisierung eingesetzt:

Anorganische Analytik / Elementaranalyse:
Die in den Beispielen angegebenen C-Gehalte wurden mit einem Leco CS 230 Analysator ermittelt, zur Bestimmung von O- und ggf. N- bzw. H-Gehalten wurde ein Leco TCH-600 Analysator eingesetzt. Die qualitative und quantitative Bestimmung von anderen angegebenen Elementen erfolgte mittels ICP- (inductively coupled plasma) Emissionspektrometrie (Optima 7300 DV, Fa. Perkin Elmer). Die Proben wurden dazu in einer Mikrowelle (Microwave 3000, Fa. Anton Paar) sauer aufgeschlossen ($HF/HNO_3$). Die ICP-OES-Bestimmung orientiert sich an der ISO 11885 "Wasserbeschaffenheit - Bestimmung von ausgewählten Elementen durch induktiv gekoppelte Plasma-Atom-Emissionsspektrometrie (ICP-OES) (ISO 11885:2007); Deutsche Fassung EN ISO 11885:2009", die zur Untersuchung saurer, wässriger Lösungen eingesetzt wird (z.B. angesäuerte Trinkwasser-, Abwasser- und andere Wasserproben, Königswasserextrakte von Böden und Sedimenten).

Partikelgrößenbestimmung:
Die Bestimmung der Partikelgrößenverteilung erfolgte im Rahmen dieser Erfindung nach ISO 13320 mittels statischer Laserstreuung mit einem Horiba LA 950. Dabei muss bei der Vorbereitung der Proben besondere Sorgfalt auf die Dispergierung der Partikel in der Messlösung aufgewendet werden, um statt der Größe von Einzelpartikeln nicht die Größe von Agglomeraten zu messen. Die Partikel wurden für die Messung in Ethanol dispergiert. Dazu wurde die Dispersion vor der Messung bei Bedarf 4 min in einem Hielscher Ultraschall-Laborgerät Modell UIS250v mit Sonotrode LS24d5 mit 250 W Ultraschall behandelt.

Oberflächenmessung nach BET:
Die spezifische Oberfläche der Materialien wurde über Gasadsorption mit Stickstoff mit einem Gerät Sorptomatic 199090 (Porotec) oder Gerät SA-9603MP (Horiba) nach der BET-Methode gemessen (Bestimmung nach DIN ISO 9277:2003-05 mit Stickstoff).

Skelettdichte:
Die Skelettdichte, d.h. die Dichte des porösen Festkörpers basierend auf dem Volumen ausschließlich der von außen gaszugänglichen Porenräume, wurde mittels He-Pyknometrie gemäß DIN 66137-2 bestimmt.

Gaszugängliches Porenvolumen:
Das gaszugängliche Porenvolumen nach Gurwitsch wurde durch Gassorptionsmessungen mit Stickstoff gemäß DIN 66134 bestimmt.

Umsatz:
Der Umsatz berechnet sich als Quotient aus der Stoffmenge in mol des umgesetzten, bezogen auf die Stoffmenge in mol des eingesetzten, Ausgangsstoffs (Edukt). Er zeigt in diesen Beispielen, wie viel von den eingesetzten $SiH_4$ Molekülen zu Si umgewandelt werden.

$$Umsatz\ SiH_4\ in\ \% = \frac{Stoffmenge\ an\ gewonnenem\ Si}{Stoffmenge\ an\ eingesetztem\ SiH_4} * 100\%$$

Ausbeute:
Die Ausbeute ist der Quotient aus der Masse an real gewonnenem Produkt und der theoretisch maximal möglichen Produktmasse. Die Ausbeute wird als Masseverhältnisgröße in Prozent ausgedrückt:

$$Ausbeute\ in\ \% = \frac{Tatsächliche\ Masse\ an\ Produkt}{Maximal\ mögliche\ Masse\ an\ Produkt} * 100\%$$

Sie ist ein Maß für die Verluste der durch den Gasstrom mitgerissenen Partikel.

**Beispiele**

Das eingesetzte $SiH_4$, der Qualität 4.0, wurde bei Linde GmbH erworben.
In allen Beispielen wurde der amorphe Kohlenstoff als poröses Ausgangsmaterial eingesetzt:

- spez. Oberfläche = 1907 $m^2$/g
- Porenvolumen = 0,96 $cm^3$/g
- mittlere volumengewichtete Partikelgröße D50 = 2,95 $\mu$m
- Partikeldichte = 0,7 g/$cm^3$
- kohäsiv, Einstufung als Geldart-Klasse: C

Folgende Reaktoren wurden bei der Durchführung der experimentellen Beispiele eingesetzt:

**Reaktor (erfindungsgemäß):**

Alle erfindungsgemäßen Beispiele wurden im Rahmen der speziellen Variante - die Reaktoren A, B und C sind dasselbe Gefäß - des Verfahrens durchgeführt. Der eingesetzte Reaktor bestand aus einem zylindrischen Unterteil (Becher) mit einem Innenradius $r_B$ = 121,5 mm sowie einer Höhe h = 512 mm und einem Deckel mit mehreren Anschlüssen (beispielsweise für die Gaszufuhr, Gasabfuhr, Temperatur- und Druckmessung) und einem flachen Boden. Einbauten an der Wand waren nicht vorhanden. Das Volumen des Reaktors betrug $V_B$ = 24 l. Der Umfang einer beliebigen Schnittfläche der Rotationsfläche, die sich durch Rotation der inneren Reaktorkontur um die Rotationsachse ergab, berechnet sich zu 763,4 mm. Der eingesetzte Rührer war ein mehrflügliger Wendelrührer mit einem Radius von $r_R$ = 119,5 mm. Durch den vollständigen Umlauf des Wendelrührers ergibt sich eine Rotationsfläche. Der Umfang einer beliebigen Schnittfläche senkrecht zur Rotationsachse dieser Rotationsfläche ergibt sich zu 750,8 mm. Aus den beiden Umfängen ergibt sich eine Wandgängigkeit von $W$ = 0,98. Die Höhe der Wendel entsprach ca. 75% der lichten Höhe des Reaktorinnenraums. Der Reaktor wurde so weit gefüllt, dass die Höhe des gerührten Partikelbetts geringer als die Höhe der Wendel ist. Somit befindet sich die Reaktionszone zu mehr als 50 % im Bereich des Rührers mit der Wandgängigkeit $W$ = 0,98. Der Becher wurde mit einer Mantelheizung elektrisch beheizt. Die Temperaturmessung erfolgte grundsätzlich zwischen der Heizung und dem Reaktor. Die Gaszufuhr erfolgte in der unteren Hälfte (125 mm über dem Reaktorboden) der Schüttung über zwei Tauchrohre mit einem Außendurchmesser von d = 6 mm, die das Gas direkt in die bewegte Schüttung einbrachten.

**Reaktor Wirbelschicht (nicht erfindungsgemäß):**

Im nicht erfindungsgemäßen Vergleichsbeispiel 1 wurde ein Wirbelschichtreaktor eingesetzt, der aus einem zylindrischen Teil mit einem Außendurchmesser von 160 mm und mit einer Höhe von 1200 mm bestand. Der zylindrische Teil setzte sich aus einer Bodenkammer und dem eigentlichen Wirbelschichtreaktor zusammen. Die beiden Teile waren durch den gasdurchlässigen Boden voneinander getrennt. Oberhalb des zylindrischen Reaktorteils schloss sich ein Reaktorteil mit Querschnittserweiterung auf die doppelte Querschnittsfläche im Vergleich zum zylindrischen Reaktorteil an. Am oberen Ende des Reaktors befand sich ein Deckel mit Filterelementen für den Gasaustritt. Die Einstellung der Reaktionstemperatur erfolgte über die Beheizung der Reaktorwand, wobei die Höhe des beheizten Bereichs 80% der zylindrischen Länge beginnend am gasdurchlässigen Boden betrug. Als Maß für die Prozesstemperatur wurde die Temperatur zwischen Heizmantel und Reaktoraußenwand genutzt. Die Heizung erfolgte elektrisch. Das Fluidisiergas wurde entsprechend vor dem Einströmen in den Wirbelschichtreaktor mit einem Gaserhitzer vorgeheizt. Die Pulsation des Fluidisiergasstroms wurde durch den Einsatz eines direkt gesteuerten Magnetventils realisiert. Als Maß für die Qualität der Wirbelschicht wurde der Fluidisierungsindex herangezogen.

In Vorversuchen wurde durch Druckverlustmessungen des Wirbelbetts die minimale Fluidisiergeschwindigkeit ermittelt.

**Definition Fluidisierungsindex:** Der Fluidisierungsindex *FI* ist definiert als das Verhältnis aus dem gemessenen Druckverlust über der Wirbelschicht $\Delta p_{WS,Messung}$ und dem theoretisch maximal erreichbaren Druckverlust $\Delta p_{WS,th}$ und wird durch die folgende Gleichung 1 berechnet:

$$FI = \frac{\Delta p_{WS,Messung}}{\Delta p_{WS,th}}$$

Der theoretisch maximal erreichbare Druckverlust berechnet sich unter Vernachlässigung der Gasdichte aus der Masse der Schüttung $m_S$, der Erdbeschleunigung $g$ und der Reaktorquerschnittsfläche $A_{WS}$ zu $\Delta p_{WS,th} = m_S \cdot g/A_{WS}$.

Bei einer vollständig fluidisierten Wirbelschicht nimmt der Fluidisierungsindex Werte von maximal 1 an.

**Bestimmung des Fluidisierungsindexes:** Der Fluidisierungsindex ist das Verhältnis aus gemessenem Druckverlust und dem theoretisch maximal möglichen Druckverlust. Es ist notwendig, für die Ermittlung des Fluidisierungsindexes den Druckverlust des Wirbelbettes messtechnisch zu erfassen. Die Druckverlustmessung erfolgt als Differenzdruckmessung zwischen unterem und oberem Ende der Wirbelschicht. Das Differenzdruckmessgerät wandelt die auf Membranen erfassten Drücke in digitale Werte um und zeigt die Druckdifferenz an. Die Druckmessleitungen sind so auszuführen, dass sie unmittelbar oberhalb des gasdurchlässigen Bodens und unmittelbar oberhalb des Wirbelbetts angeordnet sind. Für die Bestimmung des Fluidisierungsindex ist zusätzlich die genaue Erfassung des Gewichts der eingebrachten Partikelschüttung notwendig. Siehe auch [VDI-Wärmeatlas 11. Auflage, Abschnitt L3.2 Strömungsformen und Druckverlaust in Wirbelschichten, S. 1371 - 1382, Springer Verlag, Berlin Heidelberg, 2013].

**Bestimmung der minimalen Fluidisiergeschwindigkeit:** Die minimale Fluidisiergeschwindigkeit ist die auf die leere Reaktorquerschnittsfläche bezogene Fluidisiergasgeschwindigkeit, bei der die Partikelschüttung vom durchströmten Festbett in eine Wirbelschicht übergeht. Durch simultane Messung des geregelten Fluidisiergasstroms mittels Massedurchflussmesser und des Druckverlusts der Wirbelschicht mittels digitalem Differenzdruckmesser kann die minimale Fluidisiergeschwindigkeit ermittelt werden. Durch Kenntnis der Querschnittsfläche des Reaktors kann aus dem gemessenen Fluidisiergasstrom die Fluidisiergasgeschwindigkeit berechnet werden. Der aufgezeichnete Verlauf des Druckverlusts über der Fluidisiergasgeschwindigkeit wird als Wirbelschichtkennlinie bezeichnet. Es ist darauf zu achten, dass die Wirbelschichtkennlinie ausgehend von einer hohen Fluidisiergasgeschwindigkeit durch schrittweise Verkleinerung dieser Geschwindigkeit aufgenommen wird. Bei reiner Festbettdurchströmung nimmt der Druckverlust linear zu. Der zugehörige Fluidisierungsindex *FI* ist kleiner als eins. Bei einer vollausgebildeten Wirbelschicht ist der gemessene Druckverlust konstant. Der zugehörige Fluidisierungsindex *FI* ist gleich eins. Im Übergang beider Bereiche liegt der Zustand der Minimalfluidisierung vor. Die zugehörige, auf die leere Reaktorquerschnittsfläche bezogene, Fluidisiergasgeschwindigkeit ist gleich der minimalen Fluidisiergeschwindigkeit. Ist der Übergang vom Festbett zur Wirbelschicht durch einen Bereich charakterisiert, wird der Schnittpunkt der extrapolierten Festbettkennlinie und der extrapolierten Wirbelschichtkennlinie als Punkt der Minimalfluidisierung definiert. Siehe auch [VDI-Wärmeatlas 11. Auflage, Abschnitt L3.2 Strömungsformen und Druckverlust in Wirbelschichten, S. 1371 - 1382, Springer Verlag, Berlin Heidelberg, 2013].

**Reaktor Drehrohrofen (nicht erfindungsgemäß):**

Im nicht erfindungsgemäßen Vergleichsbeispiel 2 wurde ein indirekt beheizter Drehrohrofen eingesetzt. Dieser Drehrohrofen verfügte über ein um seine Längsachse rotierbares Drehrohr aus Quarzglas mit dem Durchmesser von 20 cm und beheizbarem Volumen von 30 L. Als Maß für die Prozesstemperatur wurde die Außenwandtemperatur des Quarzrohres genutzt. Die Heizung erfolgte elektrisch und konnte durch 3 Zonen geregelt werden. Zur Durchführung der Silicium-Infiltrationsreaktionen sollte das Drehrohr gasdicht abgeschlossen sein.

**Vergleichsbeispiel 1 (Wirbelschicht nicht erfindungsgemäß):**

Herstellung eines Silicium-enthaltenden Materials im Wirbelschichtreaktor mit pulsiertem Fluidisiergasstrom

Es wurden 500 g eines amorphen Kohlenstoffs als poröses Ausgangsmaterial (spez. Oberfläche = 1907 $m^2$/g, Porenvolumen = 0,96 $cm^3$/g, mittlere volumengewichtete Partikelgröße $D_{50}$ = 2,95 $\mu$m, Partikeldichte = 0,7 $g/cm^3$, Geldart-Klasse C-Partikel) in den Reaktor eingefüllt.

Die Partikelschüttung wurde mit einem aus Stickstoff bestehenden Fluidisiergas fluidisiert, wobei die Gasmenge so festgelegt wurde, dass mindestens das 3-fache der in den Vorversuchen ermittelten, minimalen Fluidisierungsgeschwindigkeit vorlag. Gleichzeitig wurde mit Hilfe des Magnetventils der Gasstrom zum Schwingen angeregt, wobei die Frequenz zwischen der Offen- und Geschlossenstellung des Ventils 3 Hz betrug. Anschließend wurde die Temperatur im Reaktor auf die Solltemperatur von 430 °C erhöht. Aufgrund der Temperaturerhöhung wurde der Fluidisiergasstrom derart angepasst, dass der Fluidisierungsindex einen Wert > 0,95 annahm.

Nach Erreichen der Solltemperatur von 430°C wurde das Fluidisiergas durch Reaktivgas enthaltend 10 Vol.-% $SiH_4$ ersetzt. Die Pulsation des Gasstroms mit der Frequenz zwischen der Offen- und Geschlossenstellung des Ventils von 3 Hz blieb während und nach dem Wechsel der Fluidisiergase bestehen und weiterhin wurden sowohl die Werte für den Fluidisierungsindex von $FI$ = 0,98 als auch aufgrund der Dichteänderung der porösen Ausgangsmaterialien während der Abscheidung des Siliciums die Gasmenge des Fluidisiergases derart angepasst, dass die Werte des Fluidisierungsindex stets größer als 0,95 waren.

Nach einer Reaktionszeit von 2,6 Stunden wurde das Fluidisiergas wieder auf einen gepulsten Stickstoffstrom umgestellt. Die Heizleistung wurde reduziert. Nach Erreichen einer Temperatur von 50°C wurde der Fluidisiergasstrom auf ein Fluidisiergas, bestehend aus 5 Vol.-% Sauerstoff, in Stickstoff umgeschaltet und für 60 min gehalten, um etwaige auf der Oberfläche des erhaltenden Produkts vorhandene, reaktive Gruppen kontrolliert abreagieren zu lassen. Anschließend wurde der Reaktor auf Raumtemperatur abgekühlt.

Nach Beendigung des Prozesses wurden 990 g eines schwarzen Feststoffs aus dem Reaktor ausgeschleust. Das gewonnene Silicium-enthaltende Material wurde in ein zylindrisches Gefäß gefüllt und in einem Rhönradmischer homogenisiert. Die durch den Wirbelschichtprozess gebildeten Agglomerate ließen sich durch Siebung beseitigen. Die Reaktionsbedingungen zur Herstellung sowie die Materialeigenschaften der Silicium-Kohlenstoff-Kompositpartikel sind in Tabelle 2 zusammengefasst.

**Vergleichsbeispiel 2 (Drehrohrofen nicht erfindungsgemäß):** Herstellung eines Silicium-enthaltenden Materials nach einem nicht erfindungsgemäßen Verfahren im drehenden Rohrreaktor

Ein drehender Rohrreaktor (Bauch-Volumen 30 L) wurde mit 0,9 kg des gleichen porösen Kohlenstoffs wie in dem Vergleichsbeispiel 1 (spez. Oberfläche = 1907 $m^2$/g, Porenvolumen = 0,96 $cm^2$/g, mittlere volumengewichtete Partikelgröße $D_{50}$ = 2,95 $\mu$m, Partikeldichte = 0,7 $g/cm^3$, Geldart-Klasse C-Partikel) beladen. Nach Inertisierung mit Stickstoff wurde der Reaktor auf 430°C erhitzt. Bei Erreichen der Reaktionstemperatur wurde das Reaktivgas (10% $SiH_4$ in $N_2$, Dosierrate 0,4 g Si / ($cm^3$*h)) für 8,5 h durch den Reaktor geleitet, dabei wurde der Reaktor mit der Drehzahl ca. 7 Umdrehungen pro Minute gedreht. Der Reaktor wurde anschließend mit Inertgas gespült. Vor der Entnahme aus dem Reaktor wurde das Produkt unter Inertgas auf Raumtemperatur abgekühlt. Die Reaktionsbedingungen zur Herstellung sowie die Materialeigenschaften der Silicium-Kohlenstoff-Kompositpartikel sind in Tabelle 2 zusammengefasst.

**Beispiele 1-5 (erfindungsgemäß):** Herstellung von Silicium-enthaltenden Materialien nach dem erfindungsgemäßen Verfahren unter Einsatz von Monosilan $SiH_4$ als Silicium-Präkursor unter Normaldruck (0,1 Mpa) (die jeweiligen Werte für die Parameter **A-D** sowie die Beispielnummer sind in Tabelle 1 zusammengefasst)

In Phase 1 des Prozesses wurde 2,4 kg des gleichen porösen Kohlenstoffs wie in dem Vergleichsbeispiel 1 und 2 (spez. Oberfläche = 1907 $m^2$/g, Porenvolumen = 0,96 $cm^3$/g, mittlere volumengewichtete Partikelgröße $D_{50}$ = 2,95 $\mu$m, Partikeldichte = 0,7 $g/cm^3$, Geldart-Klasse C-Partikel) in den erfindungsgemäßen Reaktor mit dem Rührwerk (Volumen 24 L, Durchmesser 25 cm), eingefüllt. Anschließend wurde Reaktor auf 350°C für 240 Minuten temperiert und mit Stickstoff inertisiert.

In Phase 2 wurde der Reaktor auf 430°C erhitzt. Bei Erreichen der Reaktionstemperatur wurde das Reaktivgas mit **Konzentration A** mol.-% und Porenvolumen-bezogener **Dosierrate B** für **C Stunden** durch den Reaktor geleitet. Die Gasphase wurde dem Reaktor zugeführt, während das Partikelbett durch ein erfindungsgemäßes wandgängiges Rührwerk, einem Wendelrührer, so umgewälzt wurde, dass das **Verhältnis aus Umwälzzeit zur mittleren Verweilzeit der Reaktivkomponente D** war und der Bewegungszustand der Schüttung mit Froude-Zahl 3 beschrieben werden konnte.

In Phase 3 wurde das Silicium-enthaltende Material innerhalb von 120 Minuten auf eine Temperatur von 70°C abgekühlt. Anschließend wurde der Reaktor eine Stunde mit Stickstoff, eine Stunde mit Magerluft mit einem Sauerstoffanteil von 5 Vol.-%, eine Stunde mit Magerluft mit einem Sauerstoffanteil von 10 Vol.-%, eine Stunde mit Magerluft mit einem Sauerstoffanteil von 15 Vol.-% und anschließend eine Stunde mit Luft gespült. Abschließend wurde das Produkt aus dem Reaktor entnommen.

**Tabelle 1** Versuchsparameter für die erfindungsgemäßen Beispiele 1 bis 5

| Versuchsparameter | Bezeichnung | Beispielnummer | | | | |
|---|---|---|---|---|---|---|
| | | Bsp1 | Bsp2 | Bsp3 | Bsp4 | Bsp5 |
| $SiH_4$ Konz, mol.-% | A | 10 | 50 | 50 | 100 | 100 |
| Dosierrate g Si / ($cm^3$ h) | B | 0,4 | 0,4 | 1,5 | 0,4 | 0,2 |
| Reaktionszeit Phase 2, h | C | 9,7 | 6,9 | 2,5 | 5,3 | 8,5 |
| Verhältnis t Umwälzzeit / t Verweilzeit | D | 0,075 | 0,015 | 0,015 | 0,007 | 0,007 |

Die Reaktionsbedingungen zur Herstellung sowie die Materialeigenschaften der Silicium-Kohlenstoff-Kompositpartikel sind in der folgenden Tabelle 2 zusammengefasst.

Tabelle 2

| | Vbsp 1* | Vbsp 2* | Bsp 1 | Bsp 2 | Bsp 3 | Bsp 4 | Bsp 5 |
|---|---|---|---|---|---|---|---|
| **Reaktortyp** | Wirbelschicht pulsiert | Drehrohrofen | SBR | SBR | SBR | SBR | SBR |
| **Menge Edukt, kg** | 0,5 | 0,9 | 2,4 | 2,4 | 2,4 | 2,4 | 2,4 |
| **$SiH_4$ Konz, mol.-%** | 10 | 10 | 10 | 50 | 50 | 100 | 100 |
| **Manteltemperatur Phase 2, °C** | 430 | 430 | 430 | 430 | 430 | 430 | 430 |
| **Reaktionszeit Phase 2, h** | 2,6 | 9,9 | 9,7 | 6,9 | 2,5 | 5,3 | 8,5 |
| **Reaktorvolumen, L** | 20 | 30 | 24 | 24 | 24 | 24 | 24 |
| **Reaktordurchmesser, m** | 0,15 | 0,20 | 0,25 | 0,25 | 0,25 | 0,25 | 0,25 |
| **Fr-Zahl** | n.a. | 0,005 | 3 | 3 | 3 | 3 | 3 |
| **Verhältnis t Umwälzzeit / t Verweilzeit** | n.a. | n.a. | 0,075 | 0,015 | 0,015 | 0,007 | 0,007 |
| **Porenvolumen-bezogene Dosierrate g Si / ($cm^3$*h)** | 2,6 | 0,4 | 0,4 | 0,4 | 1,5 | 0,4 | 0,2 |
| **Flächen-bezogene Dosierrate kg Si / ($m^2$*h)** | 70,1 | 10,8 | 18,2 | 18,2 | 68,1 | 18,2 | 9,1 |
| **Umsatz $SiH_4$, %** | 20 | 40 | 41 | 60 | 40 | 75 | 98 |
| **Menge Produkt, kg** | 0,99 | 1,84 | 5,67 | 5,74 | 5,51 | 5,66 | 5,80 |
| **Produkt Ausbeute, %** | 80 | 82 | 95 | 96 | 92 | 95 | 97 |
| **Partikelaustrag** | ja | ja | nein | nein | nein | nein | nein |
| **Si, Gew.-%** | 56 | 56,5 | 56 | 57 | 55 | 56 | 57 |
| **O, Gew.-%** | 3,8 | 3,04 | 2,1 | 2,64 | 3,62 | 2,64 | 2,84 |
| **BET $m^2$/g** | 11 | 10 | 23 | 26,6 | 43,6 | 26,8 | 23,8 |
| *nicht erfindungsgemäß | | | | | | | |

Unabhängig von den eingesetzten Reaktoren können gleiche charakteristische Materialkennwerte erhalten werden. Es konnten allerdings $SiH_4$-Umsatz, Produktausbeute und Reaktionszeit im erfindungsgemäßen Reaktorsystem im Vergleich zu Wirbelschicht- und Drehrohrofen verbessert werden.

**Evaluierung der Silicium-Kompositpartikel in elektrochemischen Zellen**

Beispiel 6: Anode enthaltend jeweils Material nach dem erfindungsgemäßen Verfahren erhaltenen Silicium-enthaltenden Material aus den Beispielen 1 bis 5 und nach den nichterfindungsgemäßen Verfahren erhaltenen Silicium-enthaltenden Material aus den Vergleichsbeispielen 1 und 2, ein nach dem erfindungsgemäßen Verfahren hergestelltes Silicium-enthaltendes Material und elektrochemische Testung in einer erfindungsgemäßen Lithium-Ionen-Batterie

29,71 g Polyacrylsäure (bei 85°C bis zur Gewichtskonstanz getrocknet; Sigma-Aldrich, Mw ~450.000 g/mol) und 756,60 g deionisiertes Wasser wurden mittels Schüttler (290 1/min) für 2,5 h bis zur vollständigen Lösung der Polyacrylsäure bewegt. Zu der Lösung wurde Lithiumhydroxid Monohydrat (Sigma-Aldrich) portionsweise hinzugegeben, bis der pH-Wert bei 7,0 lag (gemessen mit pH-Meter WTW pH 340i und Sonde SenTix RJD). Die Lösung wurde anschließend mittels Schüttler weitere 4 h durchmischt. 3,87 g der neutralisierten Polyacrylsäure-Lösung und 0,96 g Graphit (Imerys, KS6L C) wurden in einem 50 ml Gefäß vorgelegt und in einem Planetenmischer (SpeedMixer, DAC 150 SP) bei 2000 rpm vermengt. Anschließend wurden jeweils 3,35 g des nach dem erfindungsgemäßen Verfahren erhaltenen Silicium-enthaltenden Materials aus den Beispielen 1 bis 5 und nach den nichterfindungsgemäßen Verfahren erhaltenen Silicium-enthaltenden Materials aus den Vergleichsbeispielen 1 und 2 bei 2000 rpm für 1 min untergerührt. Anschließend wurden 1,21 g einer 8 prozentigen Leitrußdispersion und 0,8 g deionisiertes Wasser zugegeben und bei 2000 rpm am Planetenmischer eingearbeitet.

Anschließend erfolgte die Dispergierung am Dissolver für 30 min bei 3000 rpm unter konstanten 20°C. Die Entgasung der Tinte erfolgte wieder im Planetenmischer bei 2500 rpm für 5 min unter Vakuum.

Die fertige Dispersion wurde nun mittels eines Filmziehrahmens mit 0,1 mm Spalthöhe (Erichsen, Modell 360) auf eine Kupferfolie mit einer Dicke von 0,03 mm (Schlenk Metallfolien, SE-Cu58) aufgebracht. Die so hergestellte Anodenbeschichtung wurde anschließend 60 min bei 50°C und 1 bar Luftdruck getrocknet. Das mittlere Flächengewicht der trockenen Anodenbeschichtung betrug 3,0 mg/cm$^2$ und die Beschichtungsdichte 0,8 g/cm$^3$.

Die elektrochemischen Untersuchungen wurden an einer Knopfzelle (Typ CR2032, Hohsen Corp.) in 2-Elektroden-Anordnung durchgeführt. Die Elektrodenbeschichtung wurde als Gegenelektrode bzw. negative Elektrode (Dm = 15 mm) eingesetzt. Eine Beschichtung auf Basis von Lithium-Nickel-Mangan-Kobaltoxid 6:2:2 mit Gehalt von 94,0% und mittlerem Flächengewicht von 15,9 mg/cm$^2$ (bezogen von der Firma SEI) wurde als Arbeitselektrode bzw. positive Elektrode (Dm = 15 mm) verwendet. Ein mit 60 $\mu$l Elektrolyt getränktes, Glasfaser-Filterpapier (Whatman, GD Type D) diente als Separator (Dm = 16 mm). Der verwendete Elektrolyt bestand aus einer 1,0-molaren Lösung von Lithiumhexafluorophosphat in einem 1:4 (v/v) Gemisch von Fluorethylencarbonat und Diethylcarbonat. Der Bau der Zelle erfolgte in einer Glovebox (< 1 ppm H$_2$O, O$_2$), der Wassergehalt in der Trockenmasse aller verwendeten Komponenten lag unterhalb von 20 ppm.

Die elektrochemische Testung wurde bei 20°C durchgeführt. Das Laden der Zelle erfolgte im cc/cv-Verfahren (constant current/constant voltage) mit konstantem Strom von 5 mA/g (entsprechend C/25) im ersten Zyklus und von 60 mA/g (entsprechend C/2) in den darauffolgenden Zyklen und nach Erreichen der Spannungsgrenze von 4,2 V mit konstanter Spannung bis Unterschreiten eines Stroms von 1,2 mA/g (entsprechend C/100) bzw. 15 mA/g (entsprechend C/8). Das Entladen der Zelle erfolgte im cc-Verfahren (constant current) mit konstantem Strom von 5 mA/g (entsprechend C/25) im ersten Zyklus und von 60 mA/g (entsprechend C/2) in den darauffolgenden Zyklen bis Erreichen der Spannungsgrenze von 2,5 V. Der gewählte spezifische Strom bezog sich auf das Gewicht der Beschichtung der positiven Elektrode. Die Elektroden wurden so gewählt, dass ein Kapazitätsverhältnis von Kathode zu Anode von 1:1,2 eingestellt wurde.

Die Ergebnisse der elektrochemischen Testung der Vollzellen von Lithium-Ionen-Batterien enthaltend Silicium-enthaltende Materialien aus den Beispielen 1 bis 5 und den Vergleichsbeispielen 1 und 2 sind in Tabelle 3 aufgeführt.

Tabelle 3

| Beispielnummer | Reversible spezifische Kapazität der negativen Elektrode im zweiten Zyklus [mAh/g] | Zyklenzahl mit ≥ 80% Kapazitäts-erhalt | Coulomb-effizienz Formierung [%] |
|---|---|---|---|
| Vbsp 1* | 1005 | 350 | 85 |
| Vbsp 2* | 1260 | 223 | 82 |
| Bsp 1 | 1355 | 382 | 85 |
| Bsp 2 | 1186 | 542 | 85 |
| Bsp 3 | 1115 | 596 | 84 |
| Bsp 4 | 1136 | 454 | 85 |
| Bsp 5 | 1184 | 361 | 84 |

*nicht erfindungsgemäß

**Patentansprüche**

1. Verfahren zur Herstellung von Silicium enthaltenden Materialien durch thermische Zersetzung von Silicium-Präkursoren in Anwesenheit von porösen Partikeln, wobei Silicium in Poren und auf der Oberfläche der porösen Partikel abgeschieden wird,

   wobei die thermische Zersetzung der Silicium-Präkursoren in der Reaktionszone eines gasdurchströmten Reaktors stattfindet und die Partikel mittels eines in den beheizten Bereichen wandgängigen Rührers während der thermischen Zersetzung in der Reaktionszone umgewälzt werden,
   wobei das Rührwerk wandgängig ist, wenn in der Gleichung 1

$$W(h) = \frac{u_R(h)}{u_B(h)} \qquad (1)$$

   für die Hälfte aller Werte von *h* die Wandgängigkeit *W(h)* in der Reaktionszone *W(h)* > 0,9 ist, wobei $u_R(h)$ = der äußere Umfang des Rührwerks in der Schnittfläche bei der Höhenkoordinate *h* ist und $u_B(h)$ = der innere Umfang des Reaktors in der Schnittfläche bei der Höhenkoordinate *h* ist.

2. Verfahren nach Anspruch 1, bei dem die Reaktionszone des Reaktors rotationssymmetrisch ist,

   wobei das Rührwerk wandgängig ist, wenn in der Gleichung 1

$$W(h) = \frac{u_R(h)}{u_B(h)} \qquad (1)$$

   wobei
   *W(h)* = die Wandgängigkeit eines Rührwerks in einem rotationssymmetrischen Reaktor, definiert als der Quotient der Umfänge zweier ebener Schnittflächen senkrecht zur Rotationsachse von zwei Rotationsflächen, wobei *h* die Höhenkoordinate darstellt,

$u_R(h)$ = der Umfang der nach der Gleichung 2

$$u_R(h) = 2\pi r_R(h) \qquad (2)$$

an mehreren beliebigen Stellen **h** der Rotationsfläche senkrecht zur Rotationsachse durch einen ebenen Schnitt berechneten kreisförmigen inneren Schnittfläche,

$r_R(h)$ = der Abstand von der Rotationsachse zur äußeren Kontur des Rührwerks, wobei zum Rührwerk alle daran befestigten Bauteile zählen,

$u_B(h)$ = der Umfang der nach der Gleichung 3

$$u_B(h) = 2\pi r_B(h) \qquad (3)$$

an jeder beliebigen Stelle *h* der Rotationsfläche senkrecht zur Rotationsachse durch einen ebenen Schnitt berechneten kreisförmigen äußeren Rotationsfläche, die durch Rotation der inneren Kontur des Reaktors um die Rotationsachse gebildet wird,

$r_B(h)$ = der Abstand der inneren Kontur des Reaktors zur Rotationsachse,

und für die Hälfte aller Werte von **h** die Wandgängigkeit **W(h)** in der Reaktionszone **W(h)** > 0,9 sein muss.

3. Verfahren nach Anspruch 1 oder 2, bei dem über den Verlauf der Abscheidung der Silicium-Präkursor mit einer Rate von 0,1-2 g Si pro cm$^3$ Porenvolumen der eingesetzten porösen Partikel und Stunde zudosiert wird.

4. Verfahren nach Anspruch 1 oder 2, bei dem der Silicium-Präkursor über den Verlauf der Abscheidung mit einer Rate von 1-700 kg Si pro m$^2$ der größten Strömungsquerschnittsfläche des Reaktors in der Reaktionszone und Stunde zudosiert wird.

5. Verfahren nach einem der vorangehenden Ansprüche, bei dem die thermische Zersetzung der Silicium-Präkursoren bei 0,08 bis 5 Mpa stattfindet.

6. Verfahren nach einem der vorangehenden Ansprüche, bei dem die thermische Zersetzung der Silicium-Präkursoren bei 280 bis 900°C durchgeführt wird.

7. Verfahren nach einem der vorangehenden Ansprüche, bei dem die Betttemperatur in der Reaktionszone des mit dem wandgängigen Rührer ausgestatteten Reaktors im Bereich von 100 bis 1000°C liegt.

8. Verfahren nach einem der vorangehenden Ansprüche, bei dem das Verfahren in einem Kaskadenreaktorsystem umfassend mehrere Reaktoren durchgeführt wird.

9. Verfahren nach Anspruch 7, bei dem das Verfahren zumindest die Phasen 1 bis 3 umfasst:

Phase 1: Befüllen eines Reaktors A mit porösen Partikeln und Vorbehandlung der Partikel mit anschließendem Transfer der vorbehandelten Partikel in einen Reaktor B oder in einen Vorratsbehälter, oder das Material verbleibt im Reaktor A.

Phase 2: Durchströmung von Reaktor B mit einem Gas bestehend aus einem Inertgas und/oder mindestens einer Reaktivkomponente enthaltend einen Silicium-Präkursor und/oder mindestens einen Silicium-freien Präkursor, Temperieren des Reaktors auf eine Temperatur, bei der die thermische Zersetzung der Reaktivkomponente auf der Oberfläche und in den Poren der porösen Partikel stattfindet. Das Partikelbett in Reaktor B wird mit einem wandgängigen Rührer so umgewälzt, dass der Bewegungszustand der Schüttung mit Froude-Zahlen im Bereich zwischen 1 und 10 beschrieben werden kann. Die Gasphase wird Reaktor B zugeführt, während das Partikelbett in Reaktor B durch ein wandgängiges Rührorgan so umgewälzt wird, dass das Verhältnis aus Umwälzzeit zur mittleren Verweilzeit der Reaktivkomponente kleiner als 1 ist. Nach der Einbringung des Siliciums in und auf die Poren der porösen Partikel werden die Silicium-enthaltenden Materialien in Reaktor C oder zur Zwischenlagerung in einen Vorratsbehälter überführt, oder das Material verbleibt im Reaktor B.

Phase 3: Nachbehandlung der Silicium-enthaltenden Partikel zur Funktionalisierung und/oder Beschichtung der Oberfläche der Silicium-enthaltenden Partikel. Abkühlen der Partikel auf eine definierte Temperatur und Entnahme von Silicium-enthaltenden Materialien aus Reaktor C.

**Claims**

1. A process for producing silicon-containing materials by thermal decomposition of silicon precursors in the presence of porous particles, where silicon is deposited in pores and on the surface of the porous particles,

   where the thermal decomposition of the silicon precursors takes place in the reaction zone of a gas-traversed reactor and the particles are circulated in the reaction zone during the thermal decomposition by means of a stirrer which is close-clearance in the heated regions,
   where the stirring mechanism is close-clearance if in equation 1

$$W(h) = \frac{u_R(h)}{u_B(h)} \qquad (1)$$

   for half of all values of $h$ the close clearance $W(h)$ in the reaction zone is $W(h) > 0.9$, where $u_R(h)$ = the outer circumference of the stirring mechanism in the sectional face at the height coordinate $h$ and $u_B(h)$ = the inner circumference of the reactor in the sectional face at the height coordinate $h$.

2. The process as claimed in claim 1, wherein the reaction zone of the reactor is rotationally symmetrical,

   where the stirring mechanism is close-clearance if in equation 1

$$W(h) = \frac{u_R(h)}{u_B(h)} \qquad (1)$$

   where
   $W(h)$ = the close clearance of a stirring mechanism in a rotationally symmetrical reactor, defined as the quotient of the circumferences of two planar sectional faces perpendicular to the rotational axis of two rotational faces, where $h$ represents the height coordinate,
   $u_R(h)$ = the circumference of the circular inner sectional face calculated according to equation 2

$$u_R(h) = 2\pi r_R(h) \qquad (2)$$

   at multiple arbitrary points $h$ of the rotational face perpendicular to the rotational axis through a planar section, $r_R(h)$ = the distance from the rotational axis to the outer contour of the stirring mechanism, where the stirring mechanism includes all components attached thereto,
   $u_B(h)$ = the circumference of the circular outer rotational face calculated according to equation 3

$$u_B(h) = 2\pi r_B(h) \qquad (3)$$

   at each arbitrary point h of the rotational face perpendicular to the rotational axis through a planar section, said rotational face being formed by rotation of the inner contour of the reactor about the rotational axis,
   $r_B(h)$ = the distance of the inner contour of the reactor to the rotational axis,
   and for half of all values of $h$ the close clearance $W(h)$ in the reaction zone must be $W(h) > 0.9$.

3. The process as claimed in claim 1 or 2, wherein, over the course of the deposition of the silicon precursor, metered addition takes place at a rate of 0.1-2 g of Si per cm$^3$ of pore volume of the porous particles used per hour.

4. The process as claimed in claim 1 or 2, wherein, over the course of the deposition, the silicon precursor is metered in at a rate of 1-700 kg of Si per m$^2$ of the greatest flow cross-sectional area of the reactor in the reaction zone per hour.

5. The process as claimed in any of the preceding claims, wherein the thermal decomposition of the silicon precursors takes place at 0.08 to 5 MPa.

6. The process as claimed in any of the preceding claims, wherein the thermal decomposition of the silicon precursors is carried out at 280 to 900°C.

7. The process as claimed in any of the preceding claims, wherein the bed temperature in the reaction zone of the reactor equipped with the close-clearance stirrer is in the range from 100 to 1000°C.

8. The process as claimed in any of the preceding claims, wherein the process is carried out in a cascade reactor system comprising multiple reactors.

9. The process as claimed in claim 7, wherein the process comprises at least phases 1 to 3:

Phase 1: Filling of a reactor A with porous particles and pretreatment of the particles with subsequent transfer of the pretreated particles to a reactor B or to a reservoir container, or the material remains in the reactor A,

Phase 2: Passing of a flow of a gas consisting of an inert gas and/or at least one reactive component containing a silicon precursor and/or at least one silicon-free precursor through reactor B, conditioning of the reactor to a temperature at which the thermal decomposition of the reactive component takes place on the surface and in the pores of the porous particles. The particle bed in reactor B is circulated with a close-clearance stirrer such that the movement state of the particle bed can be described with Froude numbers in the range between 1 and 10. The gas phase is supplied to reactor B, while the particle bed in reactor B is circulated by a close-clearance stirring element such that the ratio of circulating time to mean residence time of the reactive component is less than 1. After the silicon has been introduced into and onto the pores of the porous particles, the silicon-containing materials are transferred to reactor C or to a reservoir container for interim storage, or the material remains in the reactor B.

Phase 3: Aftertreatment of the silicon-containing particles for functionalization and/or coating of the surface of the silicon-containing particles. Cooling of the particles to a defined temperature and withdrawal of silicon-containing materials from reactor C.

**Revendications**

1. Procédé de préparation de matériaux contenant du silicium par décomposition thermique de précurseurs de silicium en présence de particules poreuses, du silicium étant déposé dans des pores et sur la surface des particules poreuses,

la décomposition thermique des précurseurs de silicium ayant lieu dans la zone de réaction d'un réacteur traversé par du gaz et les particules étant mises en circulation dans la zone de réaction au moyen d'un agitateur à faible jeu par rapport à la paroi dans les zones chauffées pendant la décomposition thermique, l'agitateur étant à faible jeu par rapport à la paroi lorsque, dans l'équation 1

$$W(h) = \frac{u_R(h)}{u_B(h)} \qquad (1)$$

pour la moitié de toutes les valeurs de h, le faible jeu par rapport à la paroi W(h) dans la zone de réaction W(h) est > 0,9, où $u_R(h)$ = la circonférence externe de l'agitateur à l'intersection à la coordonnée de hauteur h et $u_B(h)$ = la circonférence interne du réacteur à l'intersection à la coordonnée de hauteur h.

2. Procédé selon la revendication 1, dans lequel la zone de réaction du réacteur est à symétrie de révolution,

l'agitateur étant à faible jeu par rapport à la paroi lorsque, dans l'équation 1

$$W(h) = \frac{u_R(h)}{u_B(h)} \qquad (1)$$

dans laquelle

W(h) = le faible jeu par rapport à la paroi d'un agitateur dans un réacteur à symétrie de révolution, défini comme le quotient des circonférences de deux intersections planes, perpendiculaires à l'axe de rotation de deux surfaces de rotation, où h représente la coordonnée de hauteur,

$u_R(h)$ = la circonférence de l'intersection interne circulaire calculée selon l'équation 2

$$u_R(h) = 2\pi r_R(h) \qquad (2)$$

en une pluralité d'emplacements quelconques h de la surface de rotation perpendiculairement à l'axe de rotation à travers une coupe plane,

$r_R(h)$ = la distance entre l'axe de rotation et le contour externe de l'agitateur, tous les composants fixés à l'agitateur étant pris en compte,

$u_B(h)$ = la circonférence de la surface de rotation circulaire externe calculée selon l'équation 3

$$u_B(h) = 2\pi r_B(h) \qquad (3)$$

en tout point h quelconque de la surface de rotation perpendiculairement à l'axe de rotation à travers une coupe plane, laquelle surface de rotation est formée par rotation du contour interne du réacteur autour de l'axe de rotation,

$r_B(h)$ = la distance entre le contour interne du réacteur et l'axe de rotation,

et pour la moitié de toutes les valeurs de h, le faible jeu par rapport à la paroi W(h) dans la zone de réaction W(h) doit être > 0,9.

3. Procédé selon la revendication 1 ou 2, dans lequel, au cours du dépôt, le précurseur de silicium est dosé à un taux de 0,1-2 g de Si par $cm^3$ de volume poreux des particules poreuses utilisées et par heure.

4. Procédé selon la revendication 1 ou 2, dans lequel le précurseur de silicium est dosé au cours du dépôt à un taux de 1-700 kg de Si par $m^2$ de la plus grande surface de section transversale d'écoulement du réacteur dans la zone de réaction et par heure.

5. Procédé selon l'une des revendications précédentes, dans lequel la décomposition thermique des précurseurs de silicium a lieu à une pression de 0,08 à 5 MPa.

6. Procédé selon l'une des revendications précédentes, dans lequel la décomposition thermique des précurseurs de silicium est réalisée à une température de 280 à 900°C.

7. Procédé selon l'une des revendications précédentes, dans lequel la température du lit dans la zone de réaction du réacteur équipé de l'agitateur à faible jeu par rapport à la paroi est située dans la plage de 100 à 1000°C.

8. Procédé selon l'une des revendications précédentes, dans lequel le procédé est réalisé dans un système de réacteurs en cascade comprenant plusieurs réacteurs.

9. Procédé selon la revendication 7, dans lequel le procédé comprend au moins les phases 1 à 3 :

phase 1 : remplissage d'un réacteur A par des particules poreuses et prétraitement des particules avec transfert consécutif des particules prétraitées dans un réacteur B ou dans une cuve de stockage, ou le matériau reste dans le réacteur A.

phase 2 : le réacteur B est traversé par un gaz constitué d'un gaz inerte et/ou d'au moins un composant réactif contenant un précurseur de silicium et/ou au moins un précurseur exempt de silicium, la température du réacteur étant réglée à une température à laquelle la décomposition thermique du composant réactif a lieu à la surface et dans les pores des particules poreuses. Le lit de particules dans le réacteur B est mis en circulation à l'aide d'un agitateur à faible jeu par rapport à la paroi de telle sorte que l'état de mouvement du lit peut être décrit par des nombres de Froude dans la plage entre 1 et 10. La phase gazeuse est introduite dans le réacteur B, tandis que le lit de particules dans le réacteur B est mis en circulation par un organe d'agitation à faible jeu par rapport à la paroi de telle sorte que le rapport du temps de mise en circulation à la durée de séjour moyenne du composant réactif est inférieur à 1. Après introduction du silicium dans et sur les pores des particules poreuses, les matériaux contenant du silicium sont transférés dans le réacteur C ou dans une cuve de stockage pour un stockage intermédiaire ou le matériau reste dans le réacteur B.

phase 3 : Post-traitement des particules contenant du silicium pour la fonctionnalisation et/ou le revêtement de la surface des particules contenant du silicium. Refroidissement des particules à une température définie et prélèvement des matériaux contenant du silicium du réacteur C.

**EP 4 452 847 B1**

**IN DER BESCHREIBUNG AUFGEFÜHRTE DOKUMENTE**

*Diese Liste der vom Anmelder aufgeführten Dokumente wurde ausschließlich zur Information des Lesers aufgenommen und ist nicht Bestandteil des europäischen Patentdokumentes. Sie wurde mit größter Sorgfalt zusammengestellt; das EPA übernimmt jedoch keinerlei Haftung für etwaige Fehler oder Auslassungen.*

**In der Beschreibung aufgeführte Patentdokumente**

- EP 1730800 B1
- US 10559812 B2
- US 10819400 B2
- EP 3335262 B1
- US 10147950 B2
- GB 2580110 B2

- US 7658340 B2
- US 20200240013 A1
- GB 2580110 B
- EP 2889097 A1
- US 2020240013 A1
- US 10147950 B1

**In der Beschreibung aufgeführte Nicht-Patentliteratur**

- **M. OBROVAC** ; **V.L. CHEVRIER**. *Chem. Rev.*, 2014, vol. 114, 11444
- **F. SCHÜTH**. *Chem. Unserer Zeit*, 2006, vol. 40, 92-103
- **VDI-WÄRMEATLAS**. Strömungsformen und Druck-verlust in Wirbelschichten. Springer Verlag, 2013, 1371-1382
- **D. GELDART**. Types of gas fluidization. *Powder Technology*, 1973, vol. 7, 258
- **SHABANIAN, J.** ; **JAFARI, R** ; **CHAOUKI, J.** Fluidization of Ultrafine Powders. *IRECHE*, vol. 4 (1), 16-50

- **CADORET, L.** ; **REUGE, N** ; **PANNALA, S** ; **SYAMLAL, M** ; **ROSSIGNOL, C** ; **DEXPERT-GHYS, J.** ; **COUFORT, C** ; **CAUSSAT, B.** Silicon Chemical Vapor Deposition on macro and submicron powders in a fluidized bed. *Powder Technol.*, 2009, vol. 190, 185-191
- **M. MÜLLER**. Feststoffmischen. *Chemie Ingenieur Technik*, 2007, vol. 79, 7
- **VDI-WÄRMEATLAS**. Abschnitt L3.2 Strömungsfor-men und Druckverlaust in Wirbelschichten. Springer Verlag, 2013, 1371-1382